(19) Europäisches Patentamt
European Patent Office
Office européen des brevets

(11) EP 2 849 186 A1

(12) **EUROPEAN PATENT APPLICATION**
published in accordance with Art. 153(4) EPC

(43) Date of publication:
**18.03.2015 Bulletin 2015/12**

(21) Application number: **13787926.8**

(22) Date of filing: **15.04.2013**

(51) Int Cl.:
***H01B 5/14*** (2006.01) ***B32B 15/01*** (2006.01)
***H01L 51/50*** (2006.01) ***H05B 33/26*** (2006.01)
***H05B 33/28*** (2006.01)

(86) International application number:
**PCT/JP2013/061167**

(87) International publication number:
**WO 2013/168516 (14.11.2013 Gazette 2013/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **08.05.2012 JP 2012106558**

(71) Applicant: **Konica Minolta, Inc.**
**Tokyo 100-7015 (JP)**

(72) Inventors:
- **IMAMURA, Atsushi**
  **Tokyo 100-7015 (JP)**
- **II, Hiromoto**
  **Tokyo 100-7015 (JP)**
- **YOSHIDA, Kazuhiro**
  **Tokyo 100-7015 (JP)**

(74) Representative: **Gille Hrabal**
**Brucknerstrasse 20**
**40593 Düsseldorf (DE)**

(54) **TRANSPARENT CONDUCTIVE FILM**

(57) A transparent conductive film (10) of the present invention has a configuration wherein a nitrogen-containing first compound layer (12), a light transmitting metal layer (13), and a nitrogen-containing second compound layer (14) are laminated in this order on a base material (11).

FIG. 1

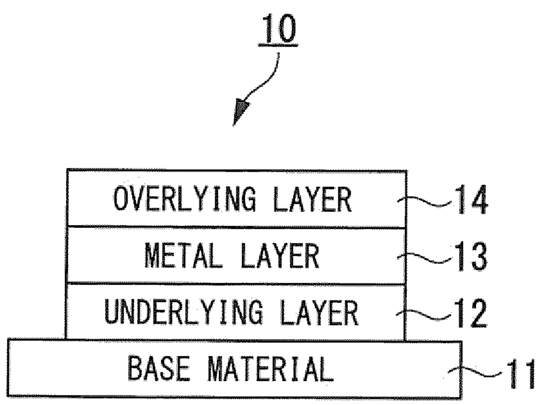


EP 2 849 186 A1

## Description

### Technical Field

The present invention relates to a transparent conductive film, and more particularly, to a transparent conductive film applicable to an electronic device having flexibility.

### Background Art

An organic electroluminescent element (hereinafter, referred to as an organic EL element) utilizing electroluminescence of an organic material is a thin-film type completely-solid state element capable of emitting light at a low voltage of several volts to several tens of volts, and has many excellent features such as high luminance, high light emission efficiency, small thickness and light weight. Accordingly, in recent years, the organic EL element has attracted attention as surface emitting bodies such as backlight of various displays, display boards such as a signboard and an emergency lamp, and illumination light sources.

Such an organic electroluminescent element has a configuration obtained by sandwiching a light emitting layer constituted using an organic material between two electrodes, the emitted light generated in the light emitting layer is extracted to the outside through the electrode. Therefore, at least one of the two electrodes is constituted as a transparent electrode.

Meanwhile, a transparent electrode having both a light transmission property in a visible light region and high electric conductivity is also utilized not only for the organic EL element but also for a solar cell, a touch panel, a liquid crystal display element, an electrode of various light-receiving elements and the like. Furthermore, a transparent electrode having the aforementioned properties is also utilized for a window of automobiles, and as a heat reflection film, an antistatic film and various antifogging transparent heat generators for a freezing showcase and the like. Moreover, the transparent electrode is usually a conductive film having small thickness and thus is also used for a flexible electronic device through the utilization of the thinness thereof.

As a material for forming the transparent electrode, a material of an oxide semiconductor such as indium tin oxide ($SnO_2$-$In_2O_3$ : ITO) is generally used, but since ITO makes use of indium being rare metal, material cost is high. Furthermore, in order to lower the resistance of an ITO film, it is necessary to perform an annealing treatment at about 300°C on an ITO film after film formation.

Accordingly, in order to reduce the resistance of a transparent electrode, conventionally, there has been proposed a technology of constituting a transparent electrode by laminating an ITO film and a silver film and of reducing the resistance (for example, see Patent Literatures 1, 2). Furthermore, conventionally, there has been proposed a technique of using a metal material such as silver having high specific conductivity as a material for forming a transparent electrode and of forming a transparent electrode by making the thickness of the conductive film thin. Moreover, conventionally, there has been proposed a technology of forming a conductive film that is thinner than a silver film alone by mixing silver with aluminum, and of securing also conductivity of the conductive film (for example, see Patent Literature 3).

### Prior Art Documents

### Patent Literature

PTL 1: Japanese Patent Laid-Open No. 2002-15623
PTL 2: Japanese Patent Laid-Open No. 2006-164961
PTL 3: Japanese Patent Laid-Open No. 2009-151963

### Summary of Invention

### Technical Problem

As described above, conventionally, in a transparent electrode (transparent conductive film), various techniques for reducing the resistance thereof have been proposed. However, even when forming a transparent electrode by using silver and aluminum each having a high electrical conductivity, it has been difficult to obtain a transparent electrode having sufficient electrical conductivity and light transmission property. Furthermore, in the case where a transparent electrode was used for a flexible electronic device, breaking of wire was sometimes generated in the transparent electrode when the electronic device was bent at a prescribed curvature.

The present invention has been achieved for solving the aforementioned problem, and objects of the present invention are to provide a transparent conductive film excellent not only in electrical conductivity and light transmission property but also in bending resistance.

Solution to Problem

In order to solve the aforementioned problems, the transparent conductive film of the present invention includes a base material, a first compound layer containing nitrogen which is provided on the base material, and a metal layer having light transmission property which is provided on the first compound layer. Furthermore, in the transparent conductive film of the present invention, a second compound layer containing nitrogen is provided on the metal layer.

Advantageous Effects of Invention

In the transparent conductive film of the present invention, by forming the metal layer on the first compound layer containing nitrogen, the metal layer can be constituted of a dense film in the formation step thereof, and the resistance of the metal layer can be reduced even when a high temperature heating treatment after the film formation is not performed. Furthermore, in the transparent conductive film of the present invention, by forming the second compound layer containing nitrogen on the metal layer, the bending resistance of the transparent conductive film can be enhanced. That is, according to the present invention, a transparent conductive film excellent not only in electrical conductivity and light transmission property but also in bending resistance can be obtained.

Brief Description of Drawings

Fig. 1 is a schematic configuration cross-sectional view of the transparent conductive film according to one embodiment of the present invention.

Description of Embodiments

Hereinafter, one example of the transparent conductive film (transparent conductive film) according to one embodiment of the present invention will be explained in order described below while referring to the drawing. Meanwhile, the scope of the present invention should be determined on the basis of the description of the claims and is not limited to the embodiments below. Furthermore, the dimensional ratio of respective portions shown in the drawing is exaggerated for convenience of explanation, and may be different from an actual ratio.

1. Configuration of transparent conductive film
2. Various Examples

<1. Configuration of transparent conductive film>

[Whole configuration of transparent conductive film]

First, the whole configuration of the transparent conductive film will be explained while referring to Fig. 1. Meanwhile, Fig. 1 is a schematic configuration cross-sectional view of the transparent conductive film according to one embodiment of the present invention. Furthermore, "transparent" in the present description means that the light transmittance at a wavelength of 550 nm is 50% or more.

A transparent conductive film 10 includes a base material 11, an underlying layer 12 (first compound layer), a metal layer 13 and an overlying layer 14 (second compound layer), as shown in Fig. 1. In addition, in the present embodiment, the underlying layer 12, the metal layer 13 and the overlying layer 14 are laminated in this order on one surface of the base material 11.

In the present embodiment, the metal layer 13 is formed of silver (Ag) or an alloy containing silver as the main component. The underlying layer 12 is formed of a compound containing a nitrogen (N) atom, and is preferably formed of a compound containing a heterocyclic ring including a nitrogen atom as a hetero atom. Furthermore, in the same way as the underlying layer 12, the overlying layer 14 is formed of a compound containing a nitrogen atom, and is preferably formed of a compound containing a heterocyclic ring including a nitrogen atom as a hetero atom. Meanwhile, the material for forming the overlying layer 14 may be the same as or different from that of the underlying layer 12.

Hereinafter, configurations of respective portions of the transparent conductive film 10 will be explained in more detail.

[Base material]

The base material 11 can be formed of, for example, glass, plastic and the like. In addition, the base material 11 may be a transparent base material, or anh opaque base material. When applying a transparent conductive film to an electronic device that extracts light from the surface on the base material 11 side of the transparent conductive film 10, the base material 11 is prefrerably a base material having transparency, and when producing a device having flexibility, the base material 11 is further prefrerably a base material having flexibility. In these cases, suitable examples of the transparent base material 11 can include a thin glass base material and a transparent resin film.

As a material for forming the glass base material, for example, silica glass, soda-lime-silica glass, lead glass, borosilicate glass, alkali-free glass and the like can be used. Meanwhile, when using the glass base material as the base material 11, from the viewpoint of close adhesion, durability and smoothness between the base material 11 and the underlying layer 12, a physical treatment such as polishing may be performed on the surface of the base material 11, or a coating film formed of an inorganic substance or an organic substance, or a hybrid coating film obtained by combining these coating films may be formed on the surface of the base material 11, as necessary.

As a material for forming a resin film, for example, polyester such as polyethylene terephthalate (PET) or polyethylene naphthalate (PEN) can be used. Furthermore, as a material for forming a resin film, for example, a material such as polyethylene, polypropylene or cellophane can be used. Moreover, cellulose esters such as cellulose diacetate, cellulose triacetate, cellulose acetate butyrate, cellulose acetate propionate (CAP), cellulose acetate phthalate (TAC) or cellulose nitrate, or derivatives thereof can be used as a material for forming a resin film.

In addition, as a material for forming a resin film, a material such as polyvinylidene chloride, polyvinyl alcohol, polyethylene vinyl alcohol, syndiotactic polystyrene, polycarbonate, norbornene resin, polymethylpentene, polyether ketone, polyimide, polyethersulfone (PES), polyphenylene sulfide, polysulfones, polyetherimide, polyetherketoneimide, polyamide, fluorine-containing resin, nylon, polymethylmethacrylate, acrylic or polyarylates can be used. Furthermore, a cycloolefin-based resin, for example, referred to as ARTON (registered trade mark : manufactured by JSR Corporation) or APEL (registered trade mark: manufactured by Mitsui Chemicals, Inc.) can also be used as a material for forming a transparent resin film.

Meanwhile, when a resin film is to be used as the base material 11, a coating film formed of an inorganic material or an organic material, or a hybrid coating film obtained by combining those films may be formed on the surface of the resin film. Such a coating film and a hybrid coating film are each preferably a barrier film (also referred to as barrier membrane or the like) having a water vapor permeability (25 $\pm$ 0.5°C, relative humidity 90 $\pm$ 2%RH) measured in accordance with the method of JIS-K-7129-1992 of 0.01 g/($m^2$·24hrs) or less. Furthermore, the coating film and the hybrid coating film are each preferably a high barrier film having an oxygen permeability measured in accordance with the method of JIS-K-7126-1987 of $10^{-3}$ ml/ ($m^2$·24hrs·atm) or less and a water vapor permeability of $10^{-5}$ g/ ($m^2$·24hrs) or less.

As a material for forming the barrier film as described above, an arbitrary material can be used as long as the material has a function of suppressing penetration of a material element that causes deterioration of an element, such as water vapor, oxygen and the like, and for example, there can be used silicon oxide, silicon dioxide, silicon nitride and the like. Furthermore, in order to improve fragility of the barrier film, it is more preferable to impart a laminated structure of an inorganic material film and an organic material film, to the barrier film. The order of lamination of the inorganic material film and the organic material film is arbitrary, and it is preferable to laminate alternately both of the material films a plurality of times.

Furthermore, an arbitrary technique can be used as a method for forming the barrier film, and there can be used, for example, a vacuum deposition method, a spattering method, a reactive spattering method, a molecular beam epitaxial method, a cluster ion beam method, an ion platting method, a plasma polymerization method, an atmospheric pressure plasma polymerization method, a plasma CVD (Chemical Vapor Deposition) method, a laser CVD method, a thermal CVD method, a coating method and the like. Among these, in the present embodiment, particularly, the use of an atmospheric pressure plasma polymerization method described in Japanese Patent Laid-Open No. 2004-68143 is preferable.

Moreover, when the base material 11 is to be formed of an opaque base material, there can be used as the base material 11, for example, a metal substrate (metal film) formed of aluminum or stainless steel, an opaque resin substrate (opaque resin film), a ceramic substrate (ceramic film) or the like.

Meanwhile, in the present embodiment, an example of providing directly the underlying layer 12 on the base material 11 is shown, but the present invention is not limited to this, and a various layers having an intended function may be provided between the base material 11 and the underlying layer 12, as necessary. For example, a planarizing layer for planarizing the surface of the base material 11 maybe provided on the surface of the base material 11. In this case, the planarizing layer is preferably a layer also having an interlaminar adhesion property, a stress relaxation property and a prevention property of bleed-out from the base material 11 and the like, at the same time.

[Underlying layer]

The underlying layer 12 is formed of a compound containing a nitrogen (N) atom, as described above, and is preferably formed of a compound containing a heterocyclic ring including a nitrogen atom as a hetero atom. Furthermore, in the present embodiment, the underlying layer 12 is preferably formed of a compound in which energy acting between the compound having a nitrogen atom contained in the underlying layer 12 and the main material (silver) contained in the metal layer 13 (hereinafter, referred to as an effective action energy ΔEef) has a value within a prescribed range.

In the present description, the effective action energy ΔEef is defined by a formula (1) below. In addotion, in the present embodiment, the underlying layer 12 is preferably formed using a compound in which the effective action energy ΔEef represented by the formula (1) below has a value within a range represented by a formula (2) below.

[Equation 1]

$$\Delta Eef = n \times \Delta E/s \quad \cdots (1)$$

[Equation 2]

$$-0.4 \leqq \Delta Eef \leqq -0.10\ [\times 10^2 kcal/(mol \cdot nm^2)] \quad \cdots (2)$$

Meanwhile, "n" in the formula (1) is the number of nitrogen (N) atoms in a compound, which are to be bonded stably with silver (Ag). "ΔE" is interaction energy between silver (Ag) and a nitrogen (N) atom. Furthermore, "s" is the surface area of the compound.

The number "n" of nitrogen atoms in a compound, which are to be bonded stably with silver, in the formula (1) is a number obtained by counting selectively only nitrogen atoms that are to be sbontably ded with silver (specific nitrogen atoms) from among nitrogen atoms contained in the compound (nitrogen atoms to be selected). Meanwhile, nitrogen atoms to be selected are the whole nitrogen atoms contained in the compound. Therefore, also when forming the underlying layer 12 with the use of a compound containing a heterocyclic ring including a nitrogen atom as a hetero atom, nitrogen atoms to be selected are the entire nitrogen atoms contained in the compound, and are not limited to nitrogen atoms constituting the heterocyclic ring. There can be used as an indicator for selecting specific nitrogen atoms from among nitrogen atoms to be selected, for example, a bond distance [r(Ag·N)] between silver and a nitrogen atom in the compound calculated by a molecular orbit calculation method, or an angle between the nitrogen atom and silver with respect to the ring containing a nitrogen atom in the compound (that is, dihedral angle "D") calculated by a molecular orbit calculation method.

(1) When using bond distance [r(Ag·N)] as indicator

When using the bond distance [r(Ag·N)] as the indicator, first, in consideration of three dimensional structures of respective compounds, a distance at which an nitrogen atom is bonded stably with silver in the compound is previously set as "stable bond distance." Subsequently, for respective nitrogen atoms contained in the compound, the bond distance [r(Ag·N)] is calculated using the molecular orbit calculation method. Meanwhile, at this time, the molecular orbit calculation is carried out, for example, using Gaussian 03 (Gaussian, Inc., Wallingford, CT, 2003).

Subsequently, nitrogen atoms for which the calculated bond distance [r(Ag·N)] exhibits a value close to the "stable bond distance" are selected as specific nitrogen atoms. Meanwhile, the selection of nitrogen atoms is applied not only to a compound containing many nitrogen atoms constituting a heterocyclic ring but also to a compound containing many nitrogen atoms not constituting a heterocyclic ring.

(2) When using dihedral angle [D] as indicator

When using the dihedral angle [D] as an indicator, first, the dihedral angle [D] in the case of nitrogen atoms in the compound is calculated using the molecular orbit calculation method. Subsequently, nitrogen atoms for which the calculated dihedral angles [D] are less than 10 degrees ([D] < 10 degrees) are selected as specific nitrogen atoms. The selection of nitrogen atoms can be applied to a compound containing many nitrogen atoms constituting a heterocyclic ring.

Furthermore, the reason why the threshold value of the dihedral angle [D] is set to be 10 degrees in the selection of nitrogen atoms is as follows. According to the inspection of present inventors, when a conductive film was formed on a compound having the dihedral angle [D] of a nitrogen atom of 10 degrees or more, the sheet resistance value of the conductive film became immeasurable, and a uniform conductive film was not able to be obtained on the compound.

From the result, it is presumed that nitrogen atoms having a dihedral angle [D] of 10 degrees or more are not involved in the interaction with silver. Therefore, when using the dihedral angle [D] as an indicator, nitrogen atoms having the dihedral angle [D] of 10 degrees or more are not selected as a specific nitrogen atom.

Moreover, the interaction energy "ΔE" between silver (Ag) and nitrogen (N) in a compound in the formula (1) can be calculated by the molecular orbit calculation method and is interaction energy between the selected nitrogen atom and silver as described above. Specifically, when energy of an interacted molecule of silver and a nitrogen atom is denoted by A, energy of a silver single body is denoted by B, and energy of a nitrogen single body is denoted by C, the interaction energy "ΔE" is calculated from A - (B + C).

Furthermore, the surface area "s" of a compound in the formula (1) is calculated using Tencube (registered trade mark)/WM (highly functional molecule modeling tool, manufactured by K. K. Tencube).

In the present embodiment, the underlying layer 12 is more preferably formed using a compound in which the effective action energy ΔEef defined as above has a value within the range shown by a formula (3) below.

[Equation 3]

$$\Delta Eef \leqq -0.20\ [\times 10^2\ kcal/(mol \cdot nm^2)] \quad \cdots (3)$$

Moreover, examples of the heterocyclic ring including a nitrogen atom as a hetero atom, contained in a compound forming the underlying layer 12 include aziridine, azirine, azetidine, azete, azolidine, azole, azinane, pyridine, azepane, azepine, imidazole, pyrazole, oxazole, thiazole, imidazoline, pyrazine, morpholine, thiazine, indole, isoindole, benzoimidazole, purine, quinoline, isoquinoline, quinoxaline, cinnoline, pteridine, acridine, carbazole, benzo-C-cinnoline, porphyrin, chlorine, choline and the like.

In addition, as a compound having a heterocyclic ring including a nitrogen atom as a hetero atom, the use of, for example, compounds represented by a general formula (1) or a general formula (2) shown below is preferable. That is, as a material for forming the underlying layer 12, it is preferable to select and use a compound represented by the general formula (1) or general formula (2) below from among various compounds that satisfy the relational formulae of the effective action energy ΔEef shown by the formulae (1) to (3).

[Chem. 1]

General formula (1)

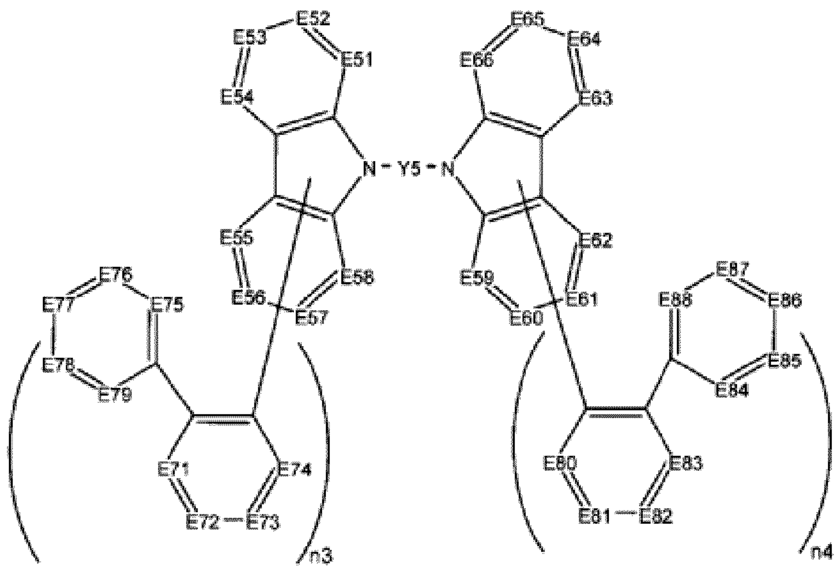

"Y5" in the general formula (1) represents a divalent linking group formed of an arylene group, a heteroarylene group or a combination thereof. Each of "E51" to "E66" and "E71" to E88" represents -C(R3)= or -N=, and R3 represents a hydrogen atom or a substituent. Meanwhile, each of at least one of "E71" to "E79" and at least one of "E80" to "E88" represents -N=. Further, each of "n3" and "n4" is an integer of from 0 to 4, and "n3" + "n4" is an integer of 2 or more.

In the general formula (1), examples of the arylene group represented by "Y5" include an o-phenylene group, a p-phenylene group, a naphthalenediyl group, an anthracenediyl group, a naphthacenediyl group, a pyrenediyl group, a naphthylnaphthalenediyl group, a biphenyldiyl group (for example, a [1,1'-biphenyl]-4,4'-diyl group, a 3,3'-biphenyldiyl group and a 3,6-biphenyldiyl group and the like), a terphenyldiyl group, a quaterphenyldiyl group, a quinquephenyldiyl group, a sexiphenyldiyl group, a septiphenyldiyl group, an octiphenyldiyl group, a nobiphenyldiyl group, a deciphenyldiyl group and the like.

Furthermore, in the general formula (1), examples of a heteroarylene group represented by "Y5" include a divalent group derived from a group consisting of a carbazole ring, a carboline ring, a diazacarbazole ring (also referred to as a monoazacarboline ring, and indicating a ring structure in which one carbon atom constituting the carboline ring is substituted with a nitrogen atom), a triazole ring, a pyrrole ring, a pyridine ring, a pyrazine ring, a quinoxaline ring, a thiophene ring, a oxadiazole ring, a dibenzofuran ring, a dibenzothiophene ring, an indole ring and the like.

As the aspect of the divalent linking group represented by "Y5" formed of an arylene group or a heteroarylene group or the combination thereof, it is preferable to contain a group derived from a condensed aromatic heterocyclic ring constituted by condensing three or more rings among heteroarylene groups, and the group derived from a condensed aromatic heterocyclic ring constituted by condensing three or more rings or a group derived from a dibenzothiophene ring.

In each of "E51" to "E66" and "E71" to "E88" in the general formula (1), examples of the substituent represented by R3 of -C (R3) = include an alkyl group (for example, methyl group, ethyl group, propyl group, isopropyl group, tert-butyl group, pentyl group, hexyl group, octyl group, dodecyl group, tridecyl group, tetradecyl group, pentadecyl group and the like), a cycloalkyl group (for example, cyclopentyl group, cyclohexyl group and the like), an alkenyl group (for example, vinyl group, allyl group and the like), an alkynyl group (for example, ethynyl group, propargyl group and the like), an aromatic hydrocarbon group (also referred to as an aromatic carbon ring group, an aryl group or the like, for example; phenyl group, p-chlorophenyl group, mesityl group, tolyl group, xylyl group, naphthyl group, anthryl group, azulenyl group, acenaphthenyl group, fluorenyl group, phenanthryl group, indenyl group, pyrenyl group, biphenyryl group and the like), an aromatic heterocyclic ring group (for example, furyl group, thienyl group, pyridyl group, pyridazinyl group, pyrimidinyl group, pyrazinyl group, triazinyl group, imidazolyl group, pyrazolyl group, thiazolyl group, quinazolinyl group, carbazolyl group, carbolinyl group, diazacarbazolyl group (a group in which a certain carbon atom constituting the carboline ring of the carbolinyl group is substituted with a nitrogen atom), phtharazinyl group and the like), a ring group (for example, pyrrolidyl group, imidazolidyl group, morpholyl group, oxazolidyl group and the like), an alkoxy group (for example, methoxy group, ethoxy group, propyloxy group, pentyloxy group, hexyloxy group, octyloxy group, dodecyloxy group and the like), a cycloalkoxy group (for example, cyclopentyloxy group, cyclohexyloxy group and the like), an aryloxy group (for example, phenoxy group, naphthyloxy group and the like), an alkylthio group (for example, methylthio group, ethylthio group, propylthio group, pentylthio group, hexylthio group, octylthio group, dodecylthio group and the like), a cycloalkylthio group (for example, cyclopentylthio group, cyclohexylthio group and the like), an arylthio group (for example, phenylthio group, naphthylthio group and the like), an alkoxycarbonyl group (for example, methyloxycarbonyl group, ethyloxycarbonyl group, butyloxycarbonyl group, octyloxycarbonyl group, dodecyloxycarbonyl group and the like), an aryloxycarbonyl group (for example, phenyloxycarbonyl group, naphthyloxycarbonyl group and the like), a sulfamoyl group (for example, aminosulfonyl group, methylaminosulfonyl group, dimethylaminosulfonyl group, butylaminosulfonyl group, hexylaminosulfonyl group, cyclohexylaminosulfonyl group, octylaminosulfonyl group, dodecylaminosulfonyl group, phenylaminosulfonyl group, naphthylaminosulfonyl group, 2-pyridylaminosulfonyl group and the like), an acyl group (for example, acetyl group, ethylcarbonyl group, propylcarbonyl group, pentylcarbonyl group, cyclohexylcarbonyl group, octylcarbonyl group, 2-ethylhexylcarbonyl group, dodecylcarbonyl group, phenylcarbonyl group, naphthylcarbonyl group, pyridylcarbonyl group and the like), an acyloxy group (for example, acetyloxy group, ethylcarbonyloxy group, butylcarbonyloxy group, octylcarbonyloxy group, dodecylcarbonyloxy group, phenylcarbonyloxy group and the like), an amido group (for example, methylcarbonylamino group, ethylcarbonylamino group, dimethylcarbonylamino group, propylcarbonylamino group, pentylcarbonylamino group, cyclohexylcarbonylamino group, 2-ethylhexylcarbonylamino group, octylcarbonylamino group, dodecylcarbonylamino group, phenylcarbonylamino group, naphthylcarbonylamino group and the like), a carbamoyl group (for example, aminocarbonyl group, methylaminocarbonyl group, dimethylaminocarbonyl group, propylaminocarbonyl group, pentylaminocarbonyl group, cyclohexylaminocarbonyl group, octylaminocarbonyl group, 2-ethylhexylaminocarbonyl group, dodecylaminocarbonyl gropup, phenylaminocarbonyl group, naphthylaminocarbonyl group, 2-pyridylaminocarbonyl group and the like), an ureido group (for example, methylureido group, ethylureido group, pentylureido group, cyclohexylureido group, octylureido group, dodecylureido group, phenylureido group, naphthylureido group, 2-pyridylaminoureido group and the like), a sulfinyl group (for example, methylsulfinyl group, ethylsulfinyl group, butylsulfinyl group, cyclohexylsulfinyl group, 2-ethylhexylsulfinyl group, dodecylsulfinyl group, phenylsulfinyl group, naphthylsulfinyl group, 2-pyridylsulfinyl group and the like), an alkylsulfonyl group (for example, methylsulfonyl group, ethylsulfonyl group, butylsulfonyl group, cyclohexylsulfonyl group, 2-ethylhexylsulfonyl group, dodecylsulfonyl group and the like), an arylsulfonyl group (for example, phenylsulfonyl group, naphthylsulfonyl group and the like), a heteroarylsulfonyl group (for example, 2-pyridylsulfonyl group and the like), an amino group (for example, amino group, ethylamino group, dimethylamino group, butylamino group, cyclopentylamino group, 2-ethylhexylamino

group, dodecylamino group, anilino group, naphthylamino group, 2-pyridylamino group, piperidyl group (also referred to as piperidinyl group), 2,2,6,6-tetramethylpiperidinyl group and the like), a halogen atom (for example, fluorine atom, chlorine atom, bromine atom and the like), a fluorinated hydrocarbon group (for example, fluoromethyl group, trifluoromethyl group, pentafluoroethyl group, pentafluorophenyl group and the like), cyano group, nitro group, hydroxyl group, mercapto group, a silyl group (for example, trimethylsilyl group, triisopropylsilyl group, triphenylsilyl group, phenyldiethylsilyl group and the like), a phosphate group (for example, dihexylphosphoryl group and the like), a phosphite group (for example, diphenylphosphinyl group and the like), phosphono group and the like.

Furthermore, substitutable sites in the aforementioned substituent may be substituted by the aforementioned substituent. Moreover, a plurality of these substituents may be bonded with each other to therefore form a ring.

In the general formula (1), preferably each of six or more of "E51" to "E58" and six or more of "E59" to "E66" is represented by -C(R3)=.

In the general formula (1), preferably each of at least one of "E75" to "E79" and at least one of "E84" to "E88" is represented by -N=.

Furthermore, in the general formula (1), preferably each of any one of "E75" to "E79" and any one of "E84" to "E88" is represented by -N=.

In the general formula (1), preferably each of "E71" to "E74" and "E80" to "E83" is represented by -C(R3)=.

Moreover, in the compound represented by the general formula (1), preferably "E53" is represented by -C (R3) = and R3 represents a liking site, and in addition, preferably "E61" is also represented by -C(R3)= at the same time and R3 represents a linking site.

Furthrmore, preferably each of "E75" and "E84" is represented by -N=, and preferably each of "E71" to "E74" and "E80" to "E83" is represented by -C(R3)=.

In addition, other examples of a compound that forms the underlying layer 12 include compounds represented by general formula (2) below.

[Chem. 2]

General formula (2)

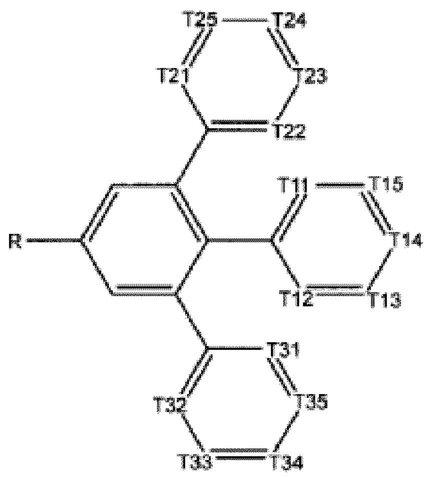

Each of "T11," "T12," "T21" to "T25" and "T31" to "T35" in the general formula (2) is represented by -C (R) = or -N=, each of "T13" to "T15" is represented by -C(R)=, and "R" represents a hydrogen atom (H) or a substituent. Meanwhile, at least one of "T11" and "T12" in the general formula (2), is -N=, at least one of "T21" to "T25" is -N=, and at least one of "T31" to "T35" is -N=.

Furthermore, examples of the substituent represented by "R" include ones that are same as examples of the substituent represented by R3 explained in the compound of the general formula (1). In addition, a substitutable site in these substituent represented by "R" may be substituted by the substituent represented by R3 explained in the compound of the general formula (1).

When forming the underlying layer 12 having the aforementioned configuration on the base material 11, as the film formation technique thereof, for example, a technique using a wet process such as an application method, an inkjet method, a coating method and dip method, or a technique using a dry process such as an evaporation method (resistance heating method, EB (Electron Beam) method and the like), a sputtering method and a CVD method can be used. Among these film formation techniques, in the present embodiment, the use of an evaporation method is preferable as the

method for forming the underlying layer 12.

[Specific example of compound]

Next, specific examples of compounds (HC1 to HC118) for forming the underlying layer 12 are shown, but the material for forming the underlying layer 12 is not limited to these examples. Furthermore, here, compounds that are not included in the general formula (1) and general formula (2) are also exemplified.

[Chem. 3]

HC1

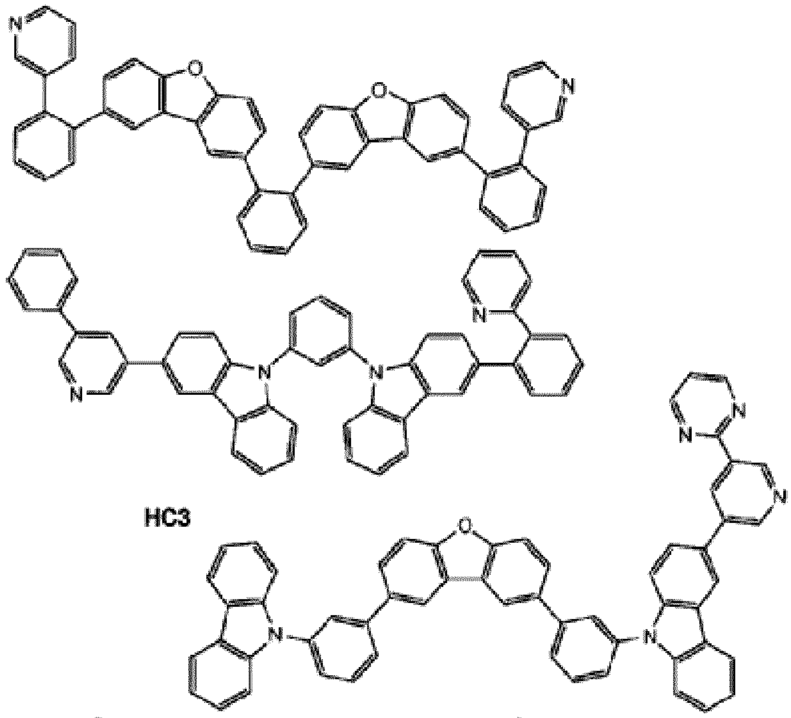

HC2

HC3

HC4

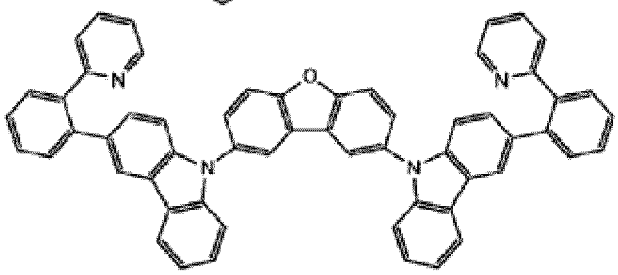

HC5

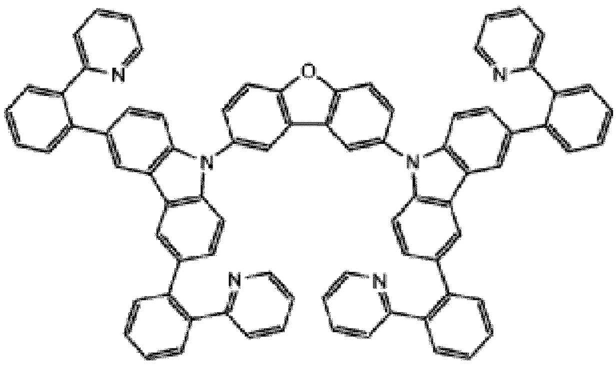

[Chem. 4]

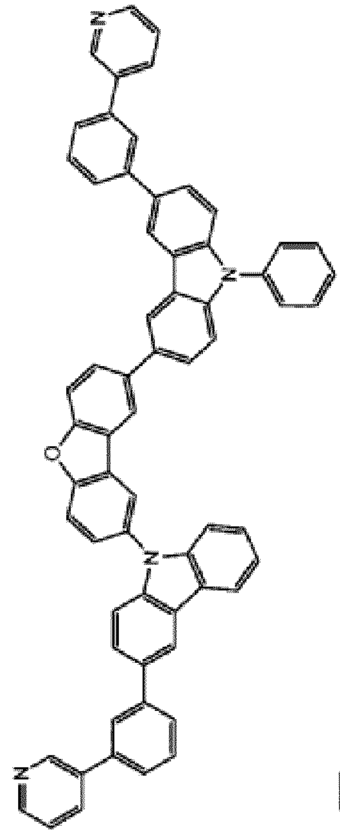

HC6

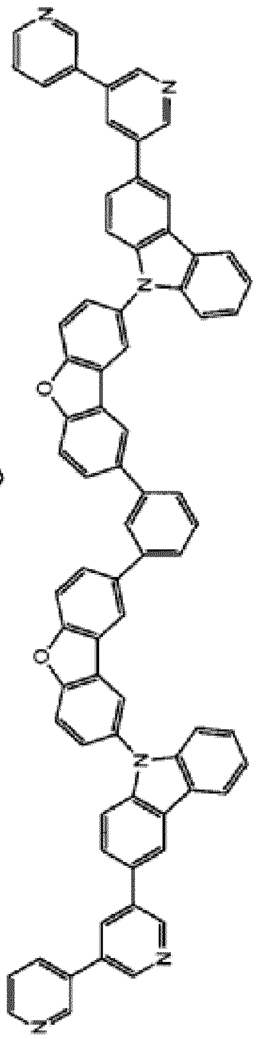

HC7

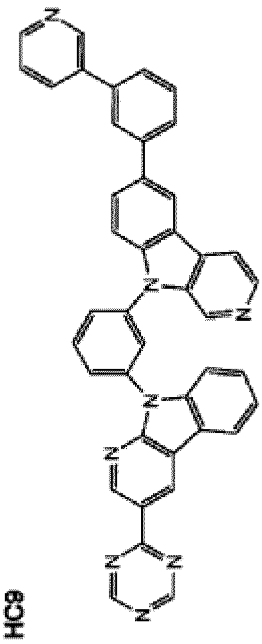

HC9

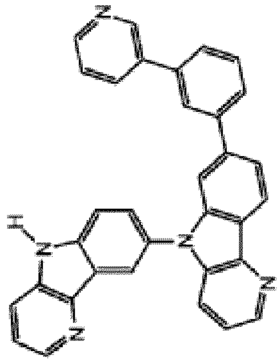

HC8

[Chem. 5]

HC10

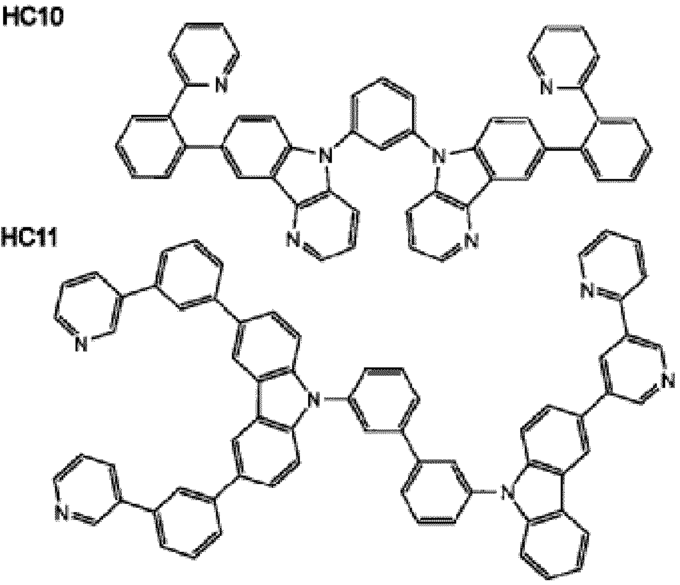

HC11

HC12

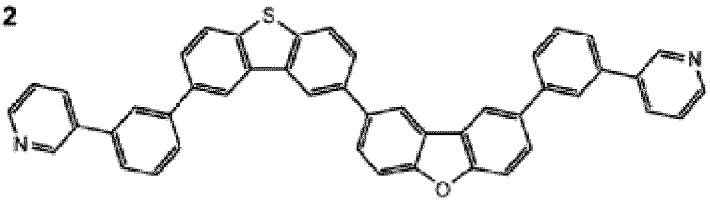

HC13

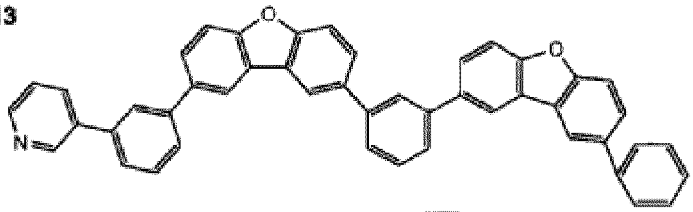

HC14

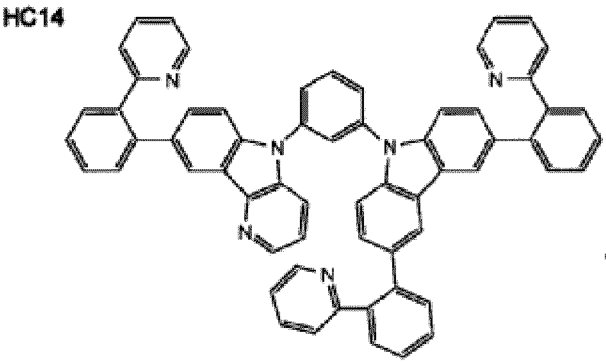

HC15

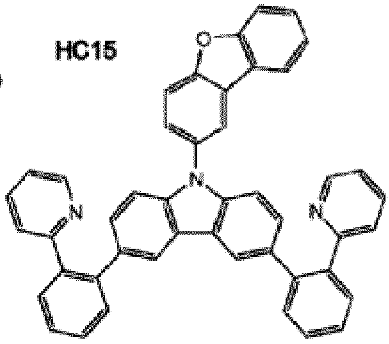

[Chem. 6]

HC16

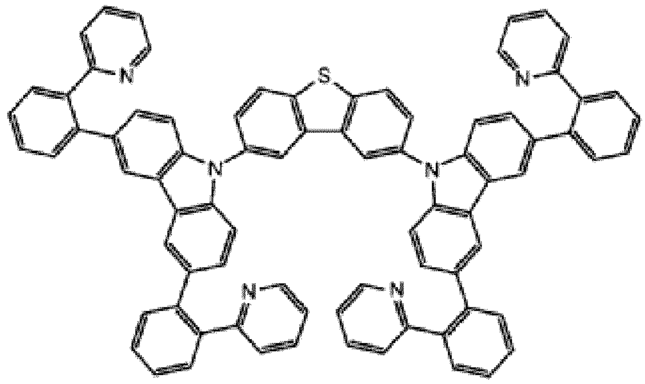

HC17

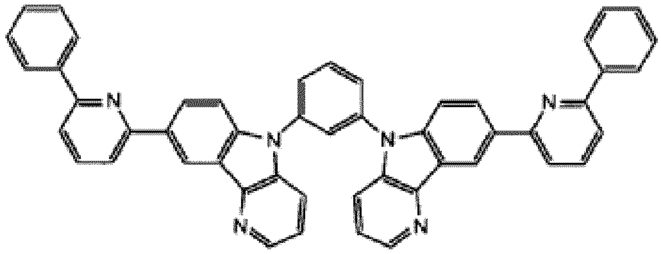

HC18

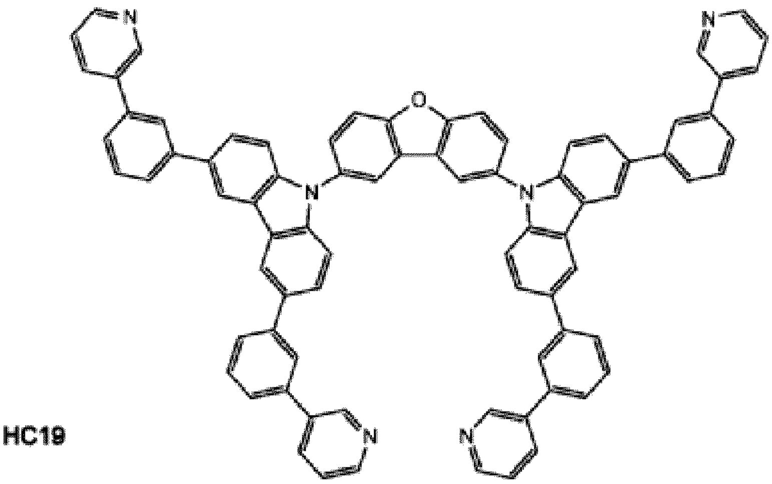

HC19

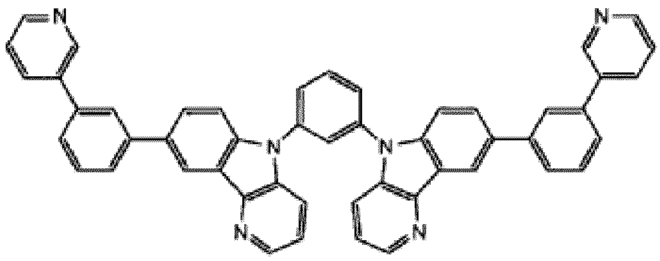

[Chem. 7]

HC20

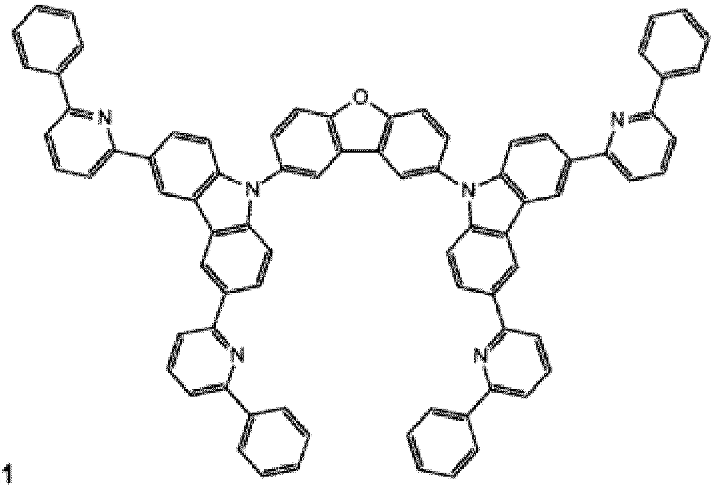

HC21

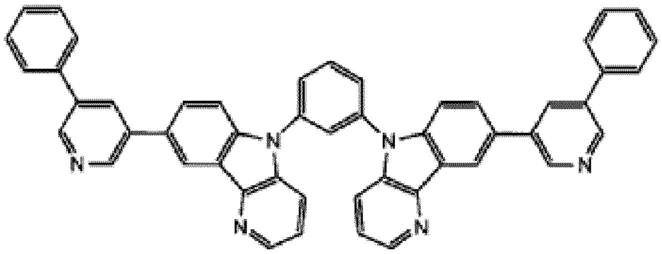

HC22

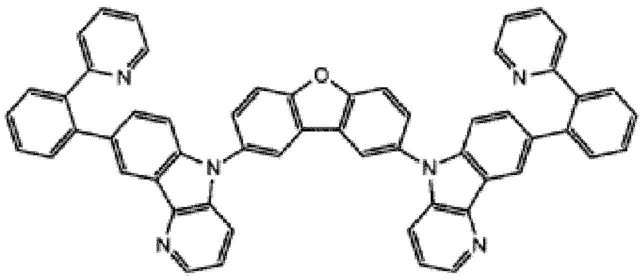

HC23

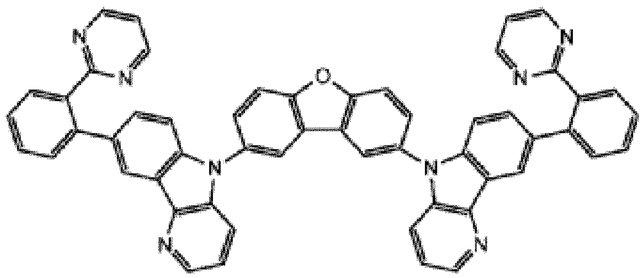

[Chem. 8]

HC24

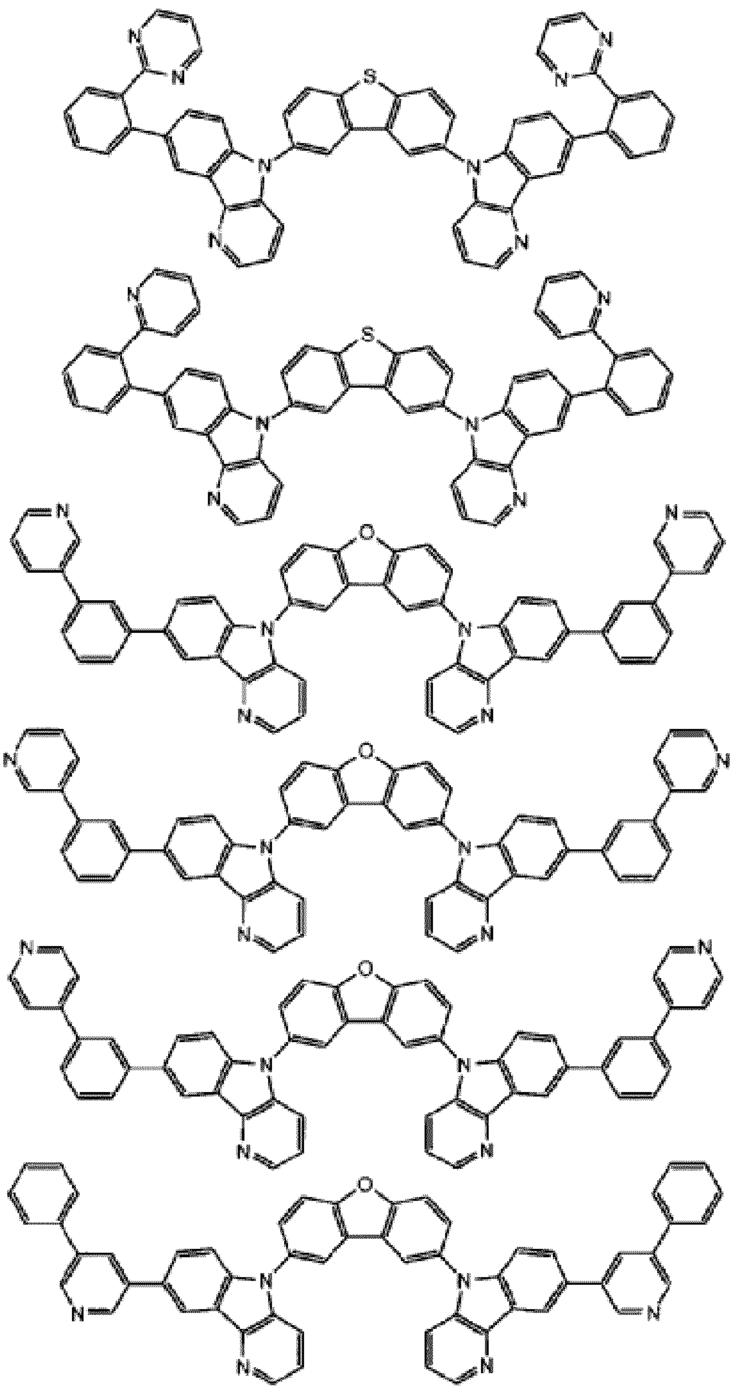

HC25

HC26

HC27

HC28

HC29

[Chem. 9]

HC30

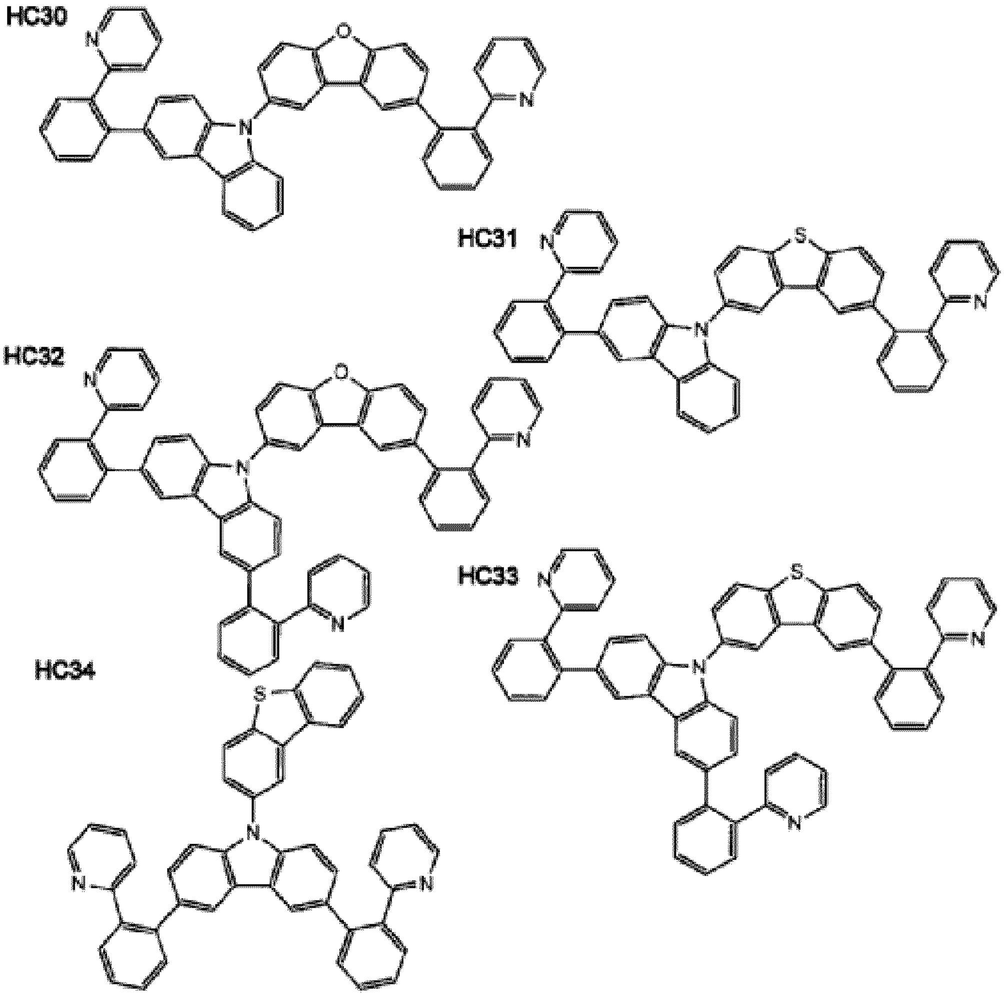

HC31

HC32

HC33

HC34

HC35

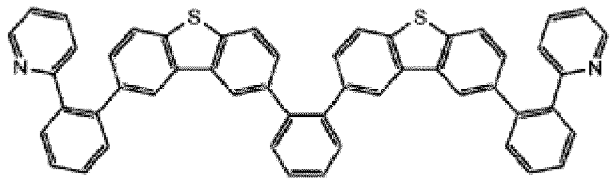

HC36

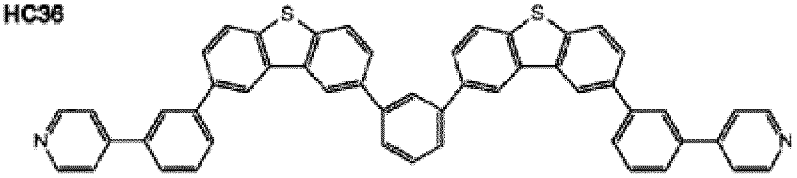

[Chem. 10]

HC37

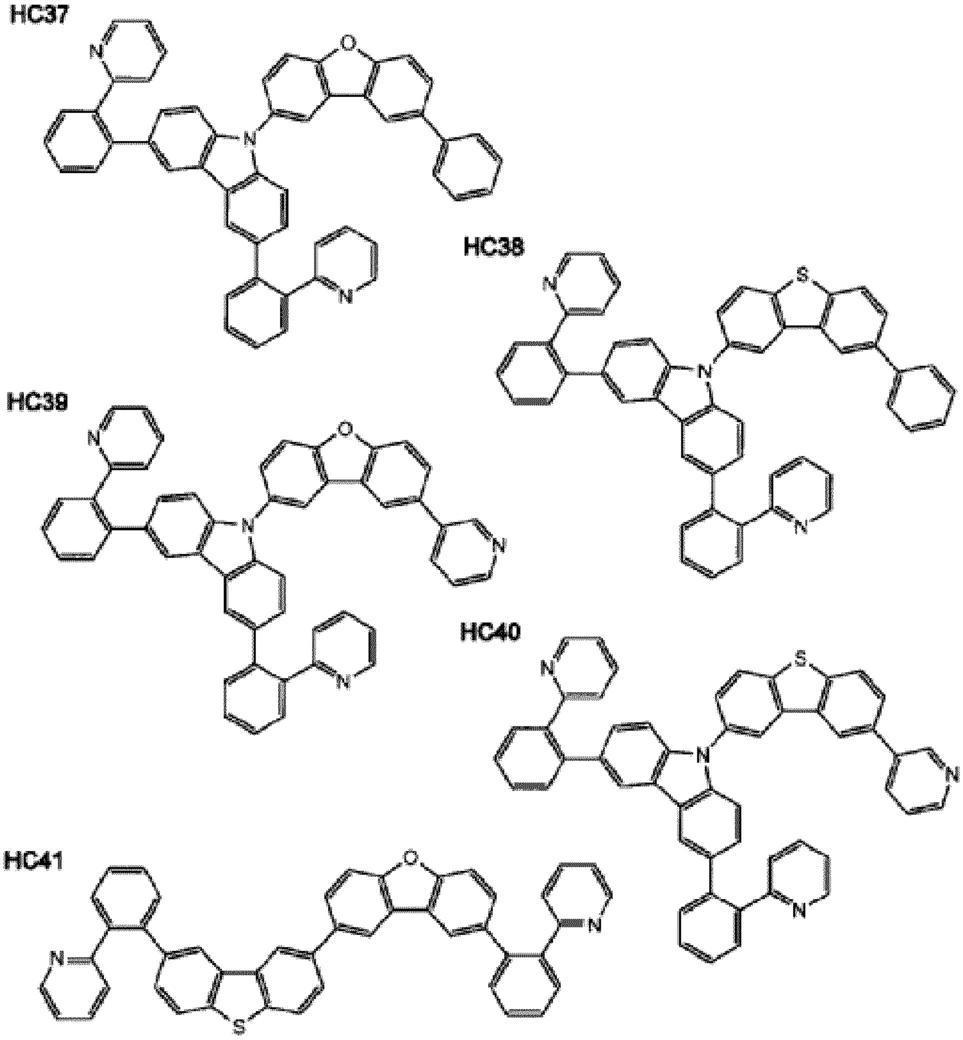

HC38

HC39

HC40

HC41

HC42

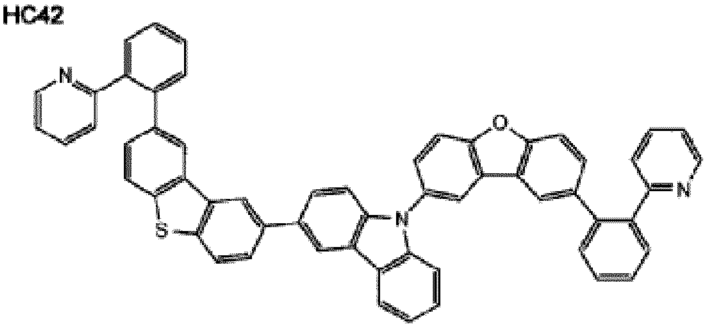

[Chem. 11]

HC43

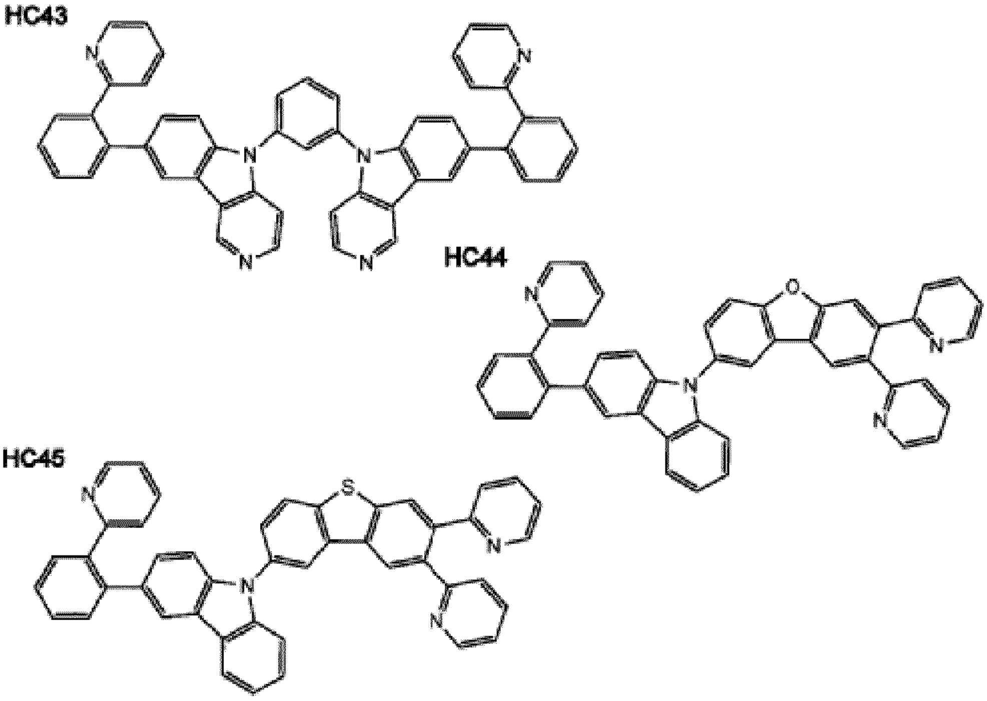

HC44

HC45

HC46

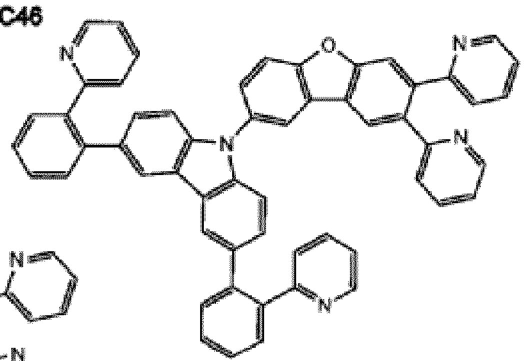

HC47

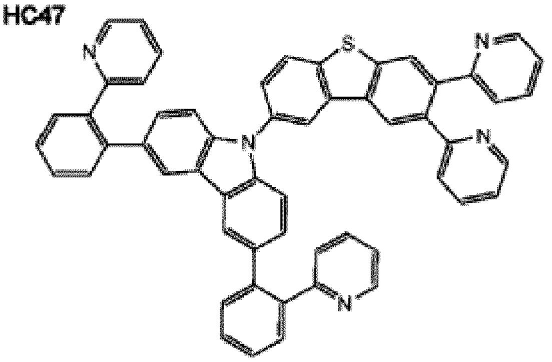

[Chem. 12]

HC48

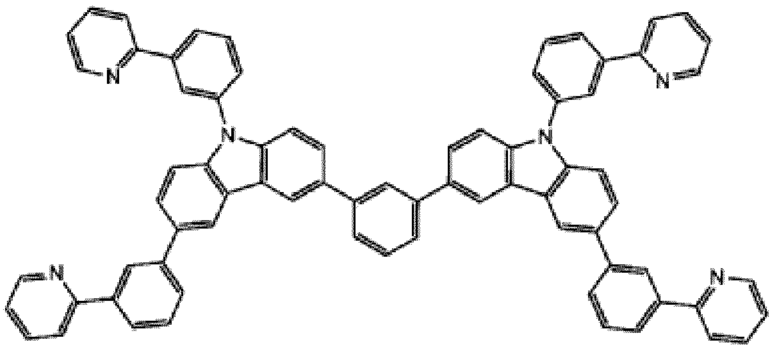

HC49

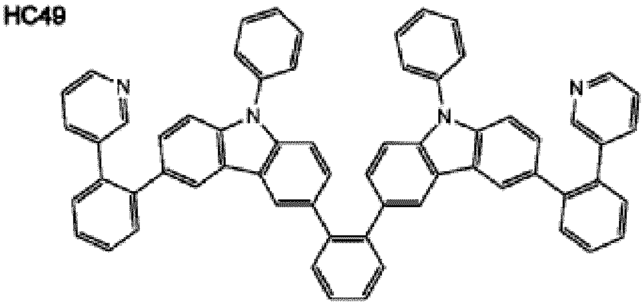

HC50

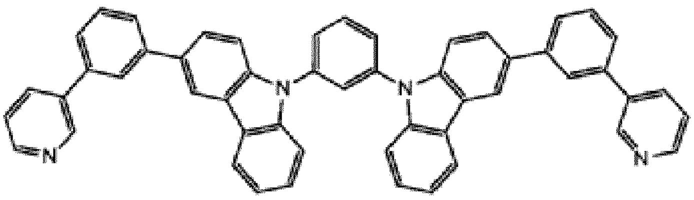

HC51

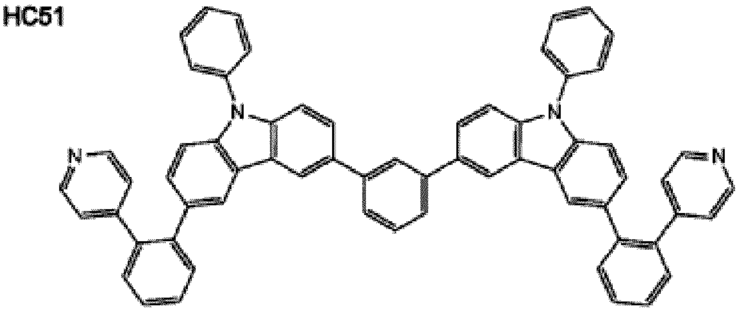

HC52

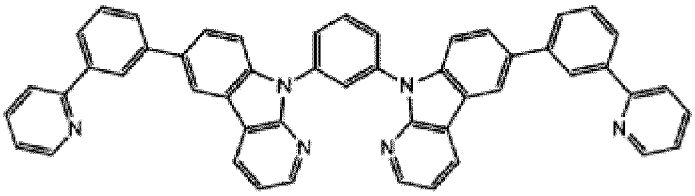

[Chem. 13]

HC53

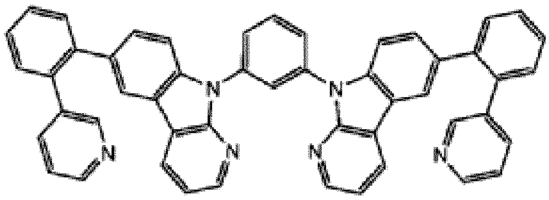

HC54

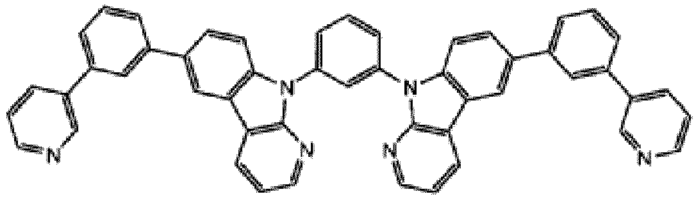

HC55

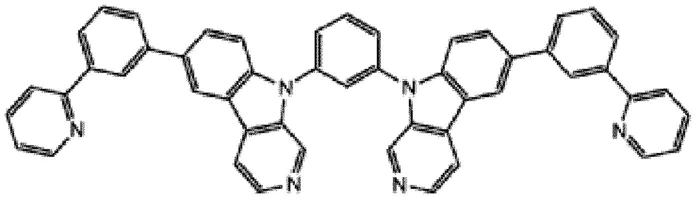

HC56

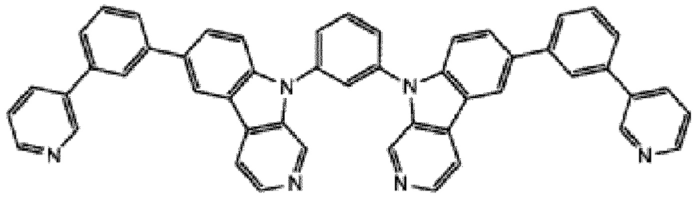

HC57

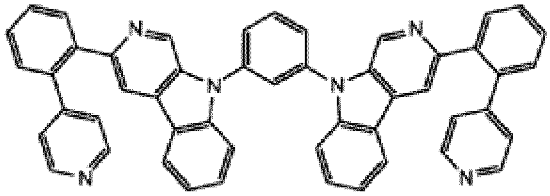

HC58

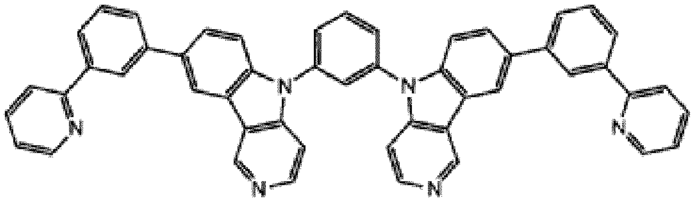

[Chem. 14]

HC59

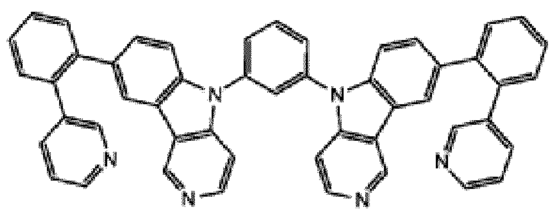

HC60

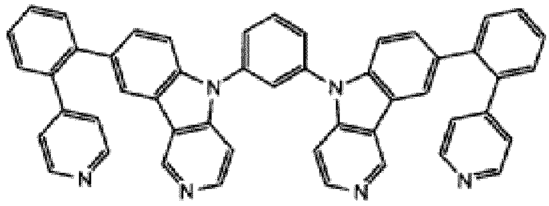

HC61

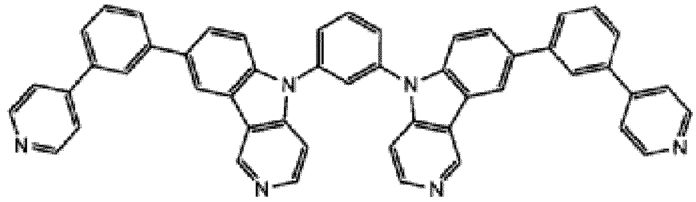

HC62

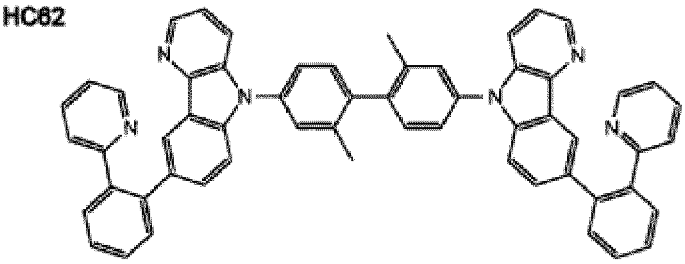

HC63

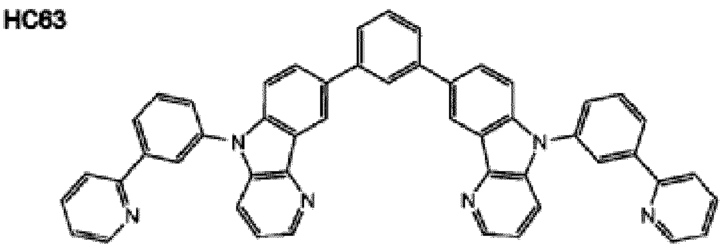

HC64

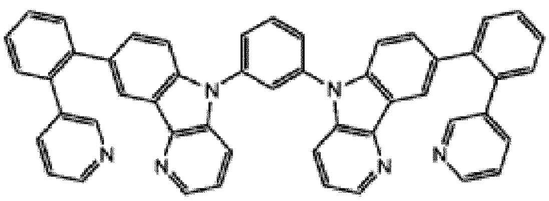

[Chem. 15]

HC65

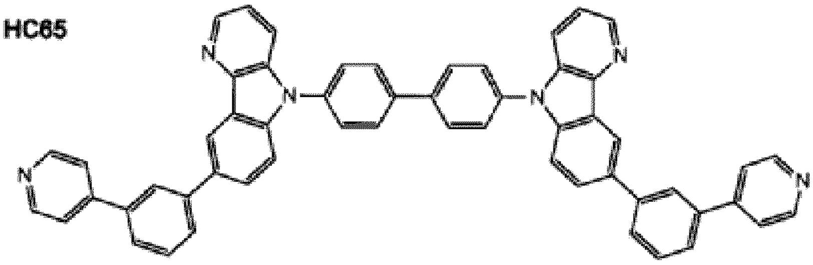

HC66

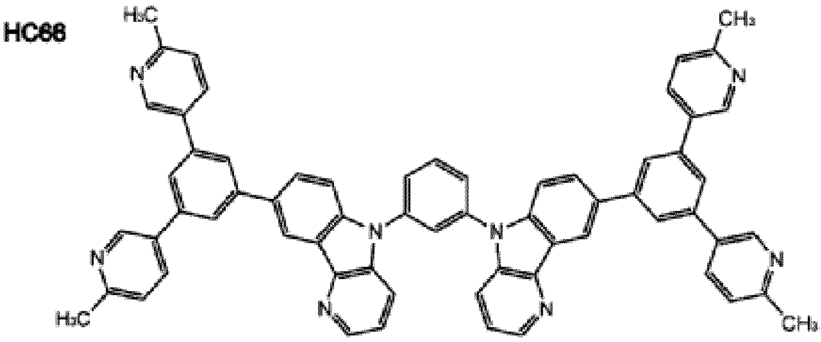

HC67

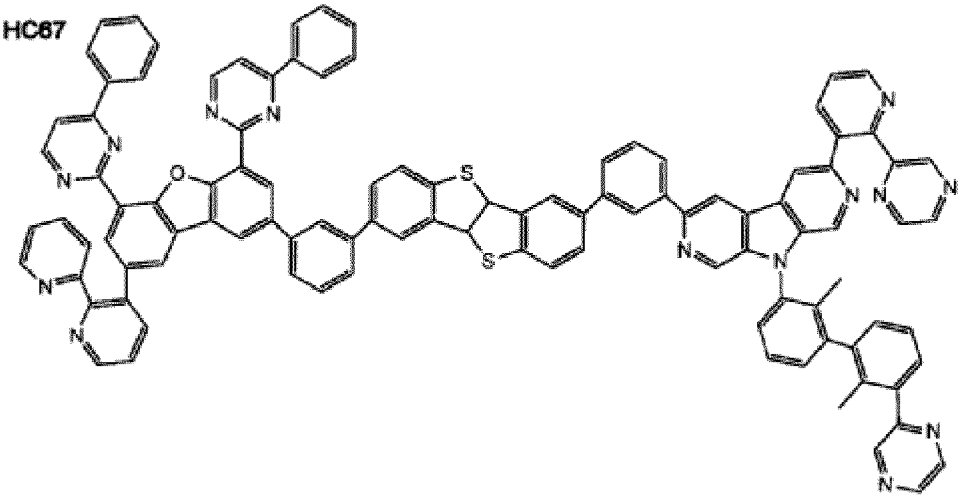

[Chem. 16]

HC68

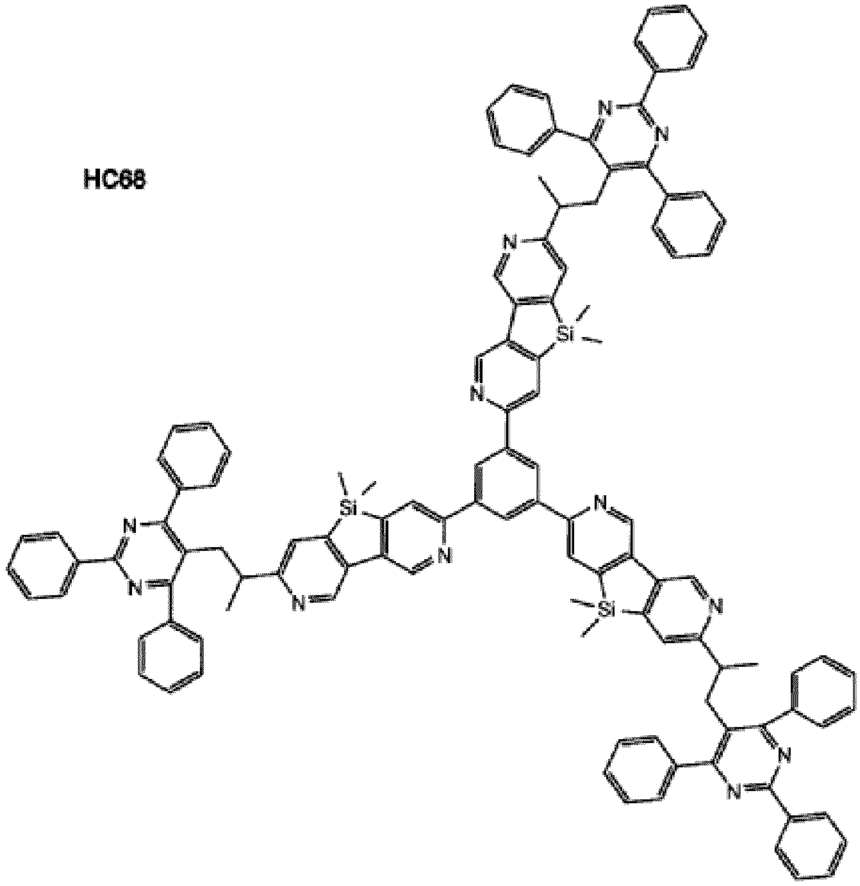

HC69

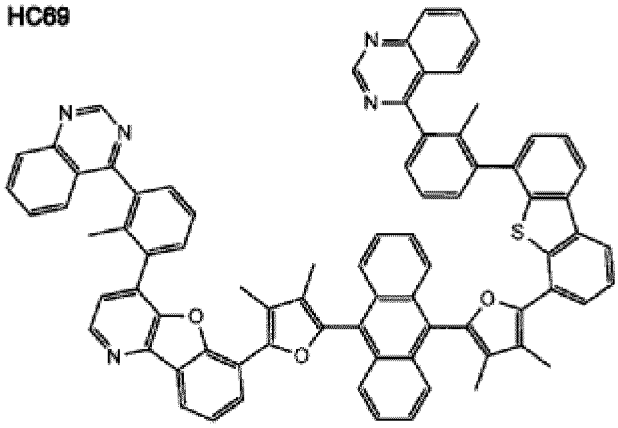

[Chem. 17]

HC70

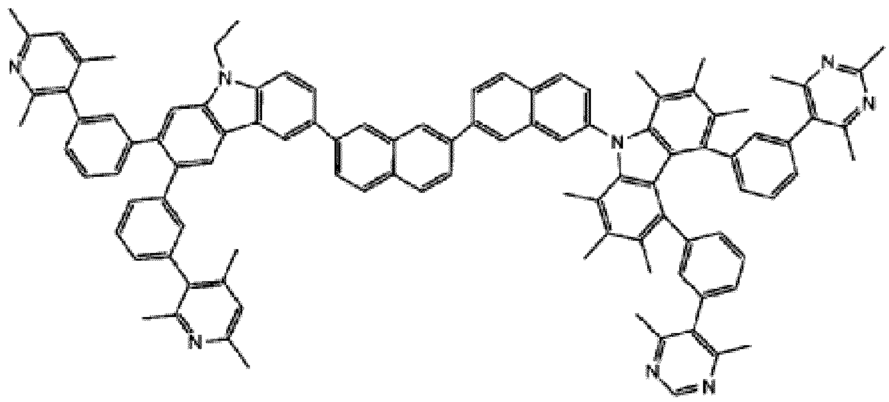

HC71

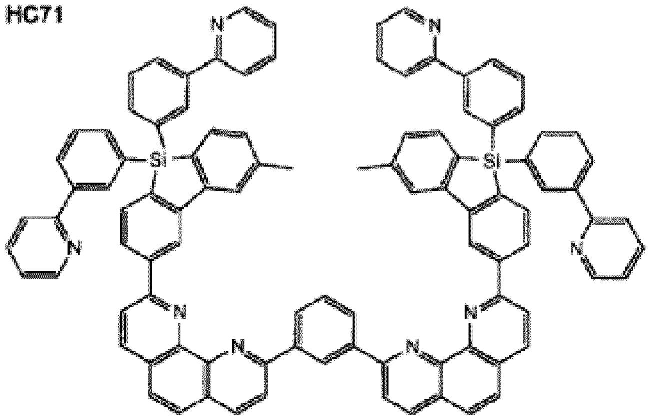

HC72

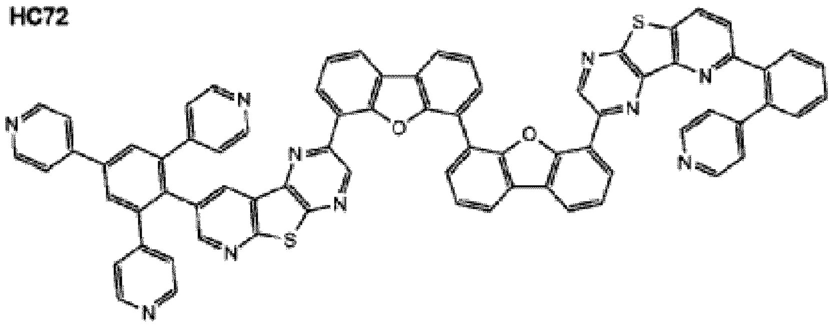

[Chem. 18]

HC73

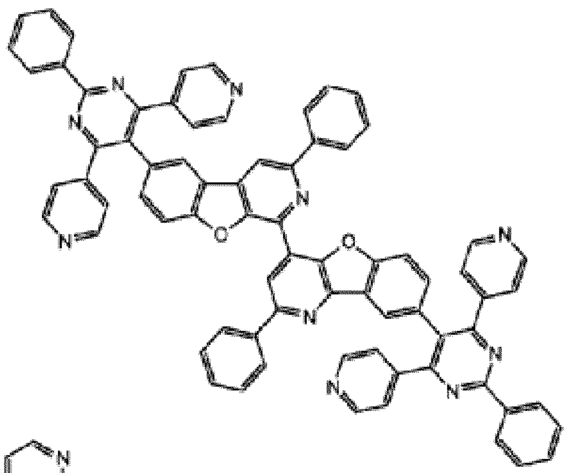

HC74

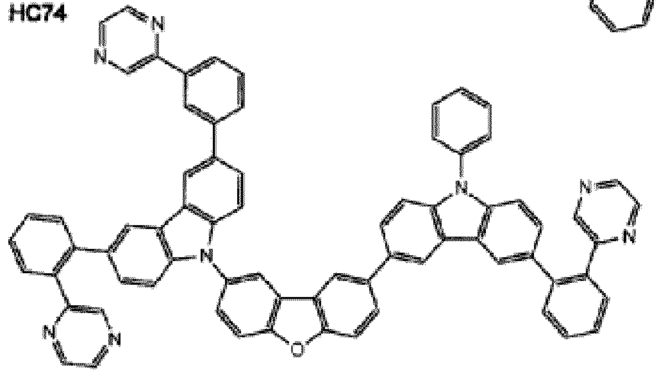

HC75

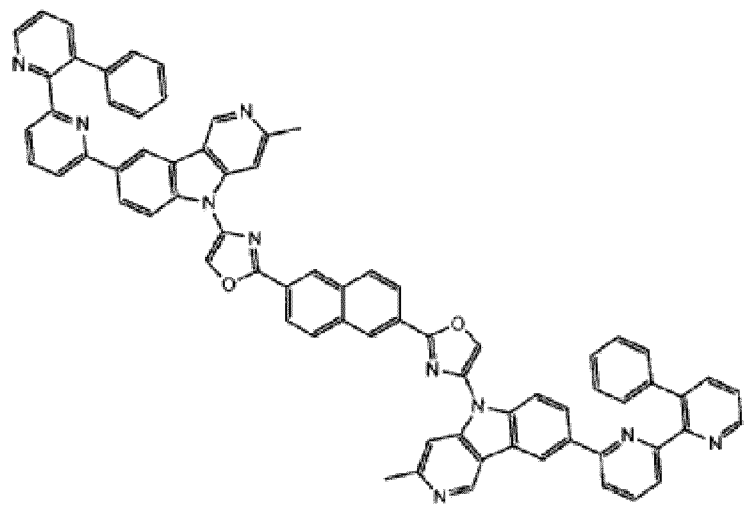

[Chem. 19]

HC76

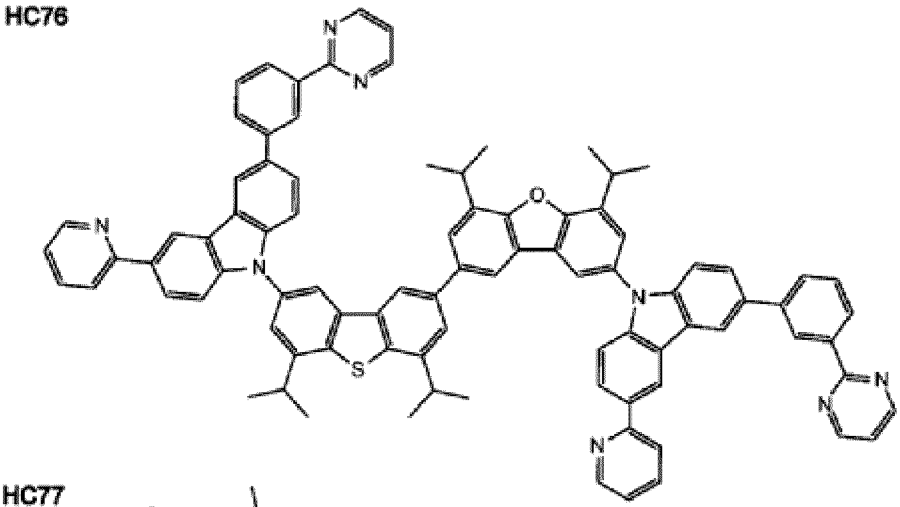

HC77

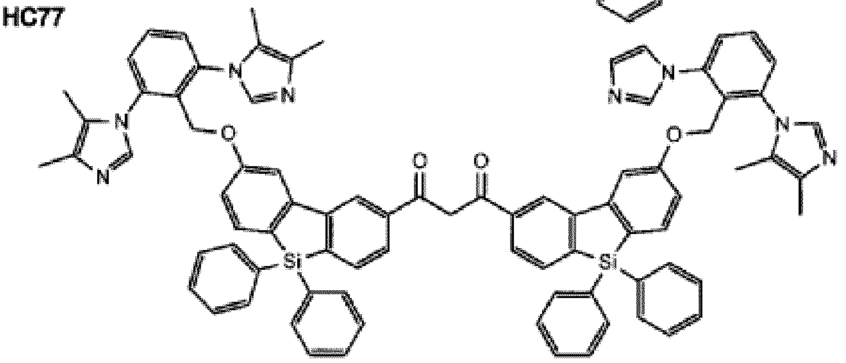

HC78

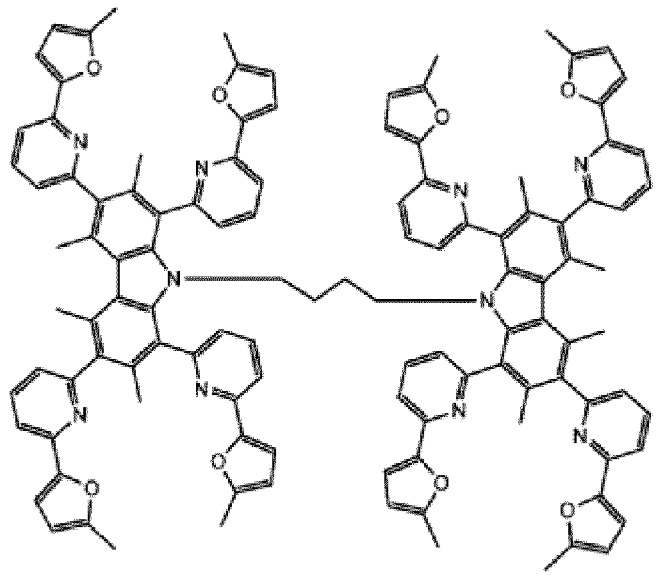

[Chem. 20]

HC79

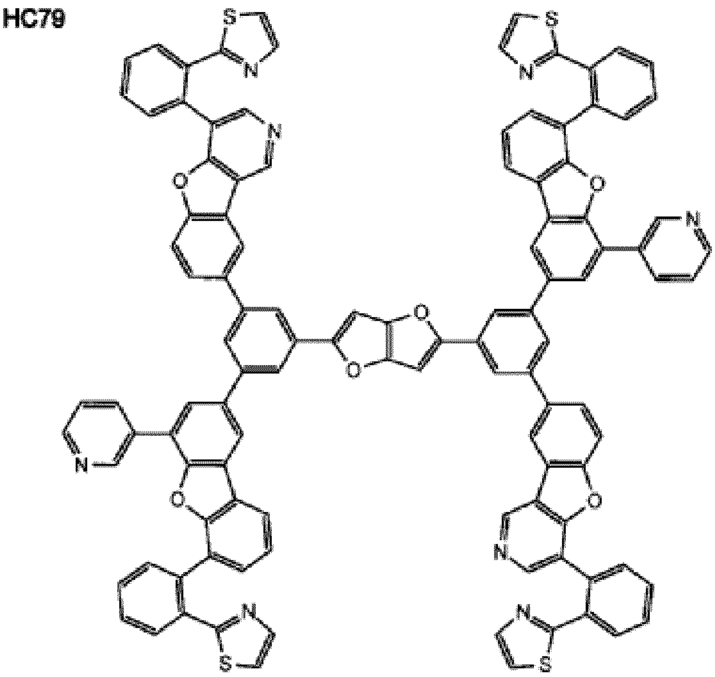

HC80

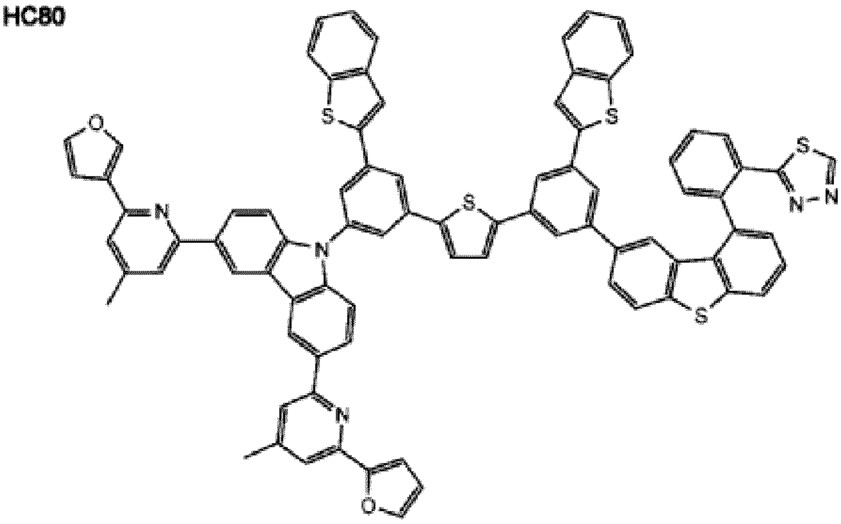

[Chem. 21]

HC81

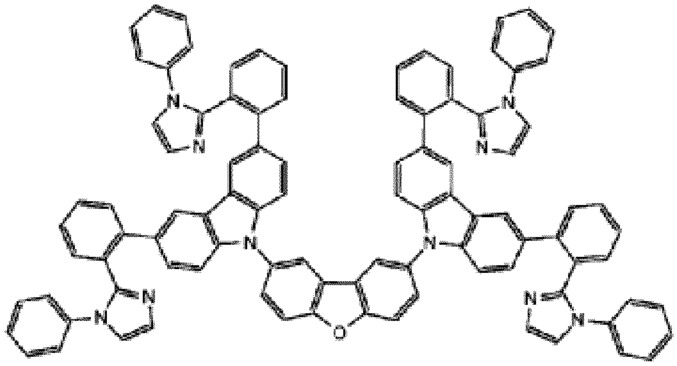

HC82

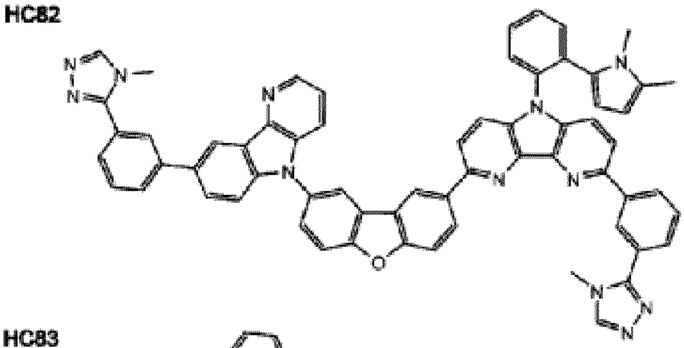

HC83

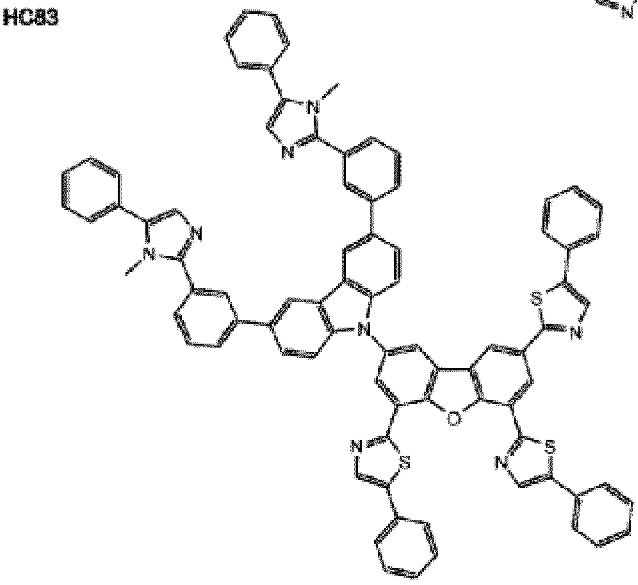

[Chem. 22]

HC84

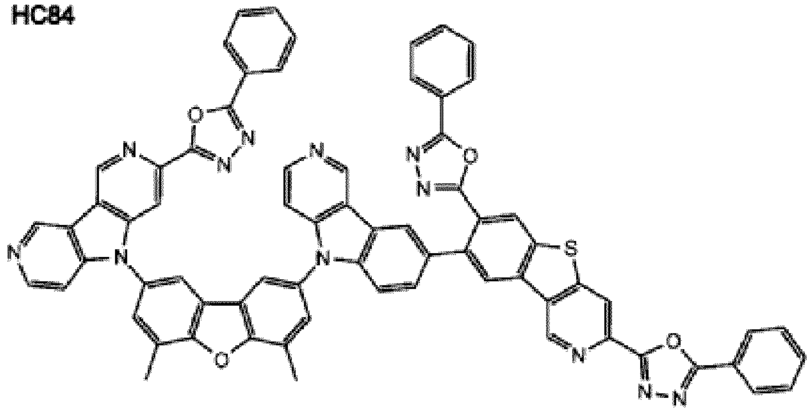

HC85

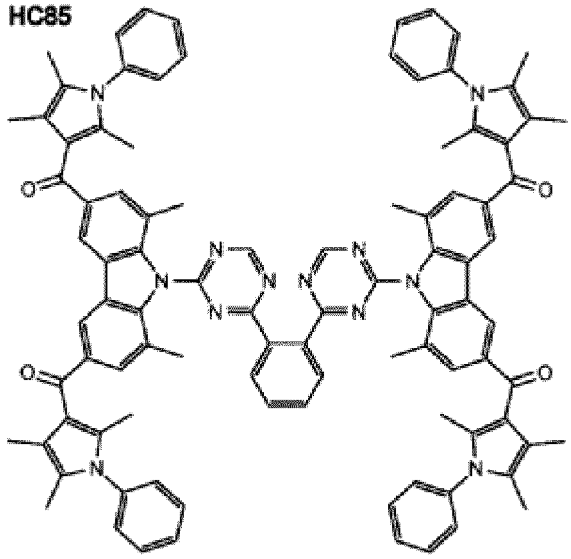

[Chem. 23]

HC86

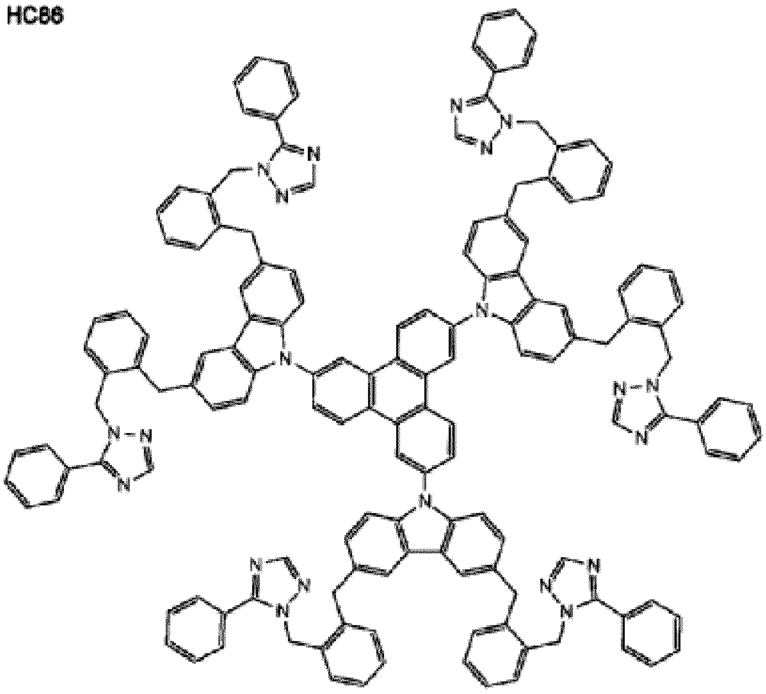

HC87

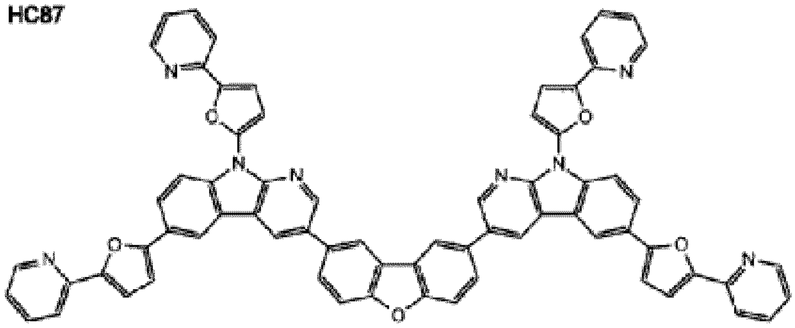

HC88

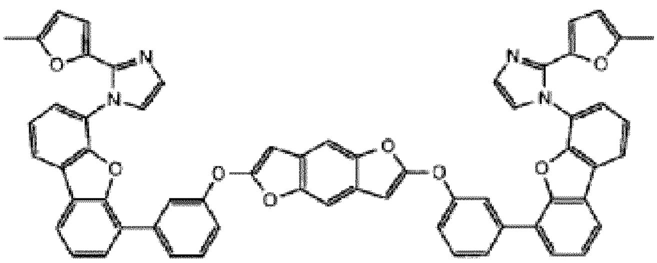

[Chem. 24]

HC89

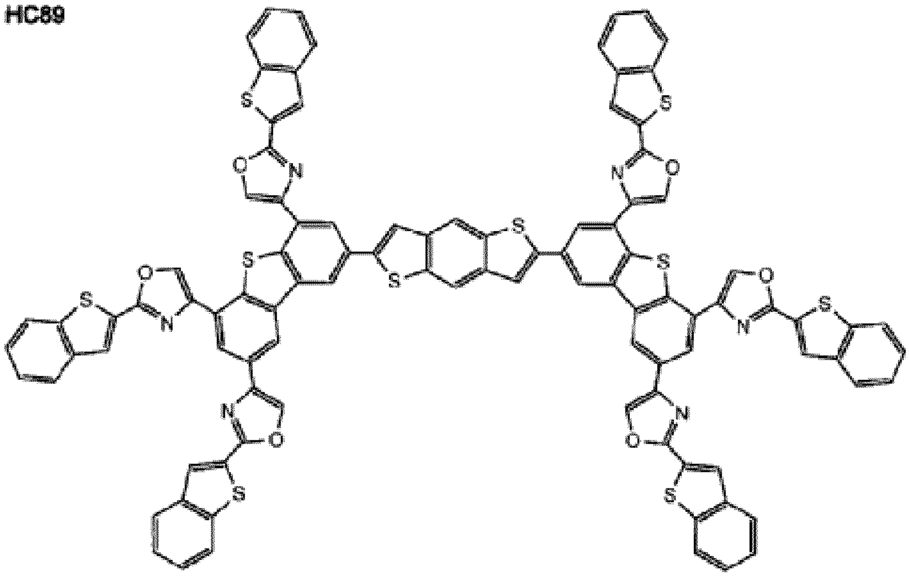

HC90

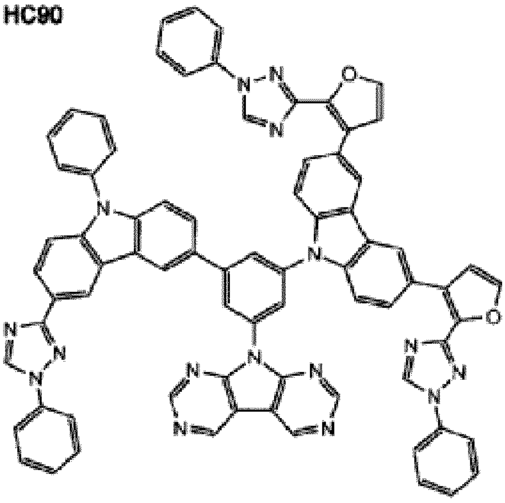

HC91

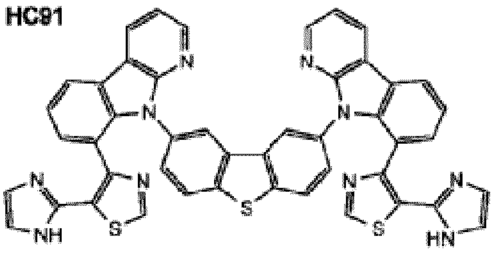

[Chem. 25]

HC92

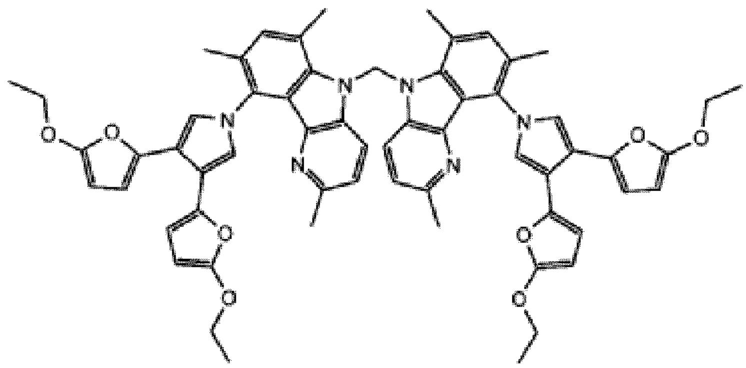

HC93

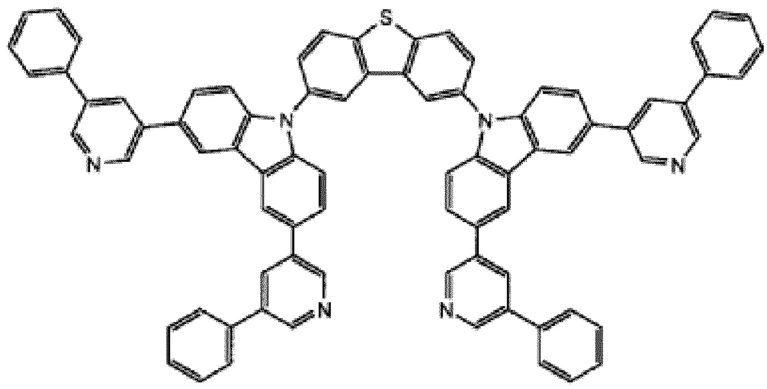

HC94

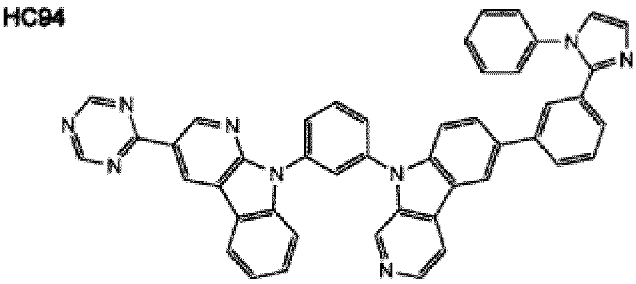

HC95

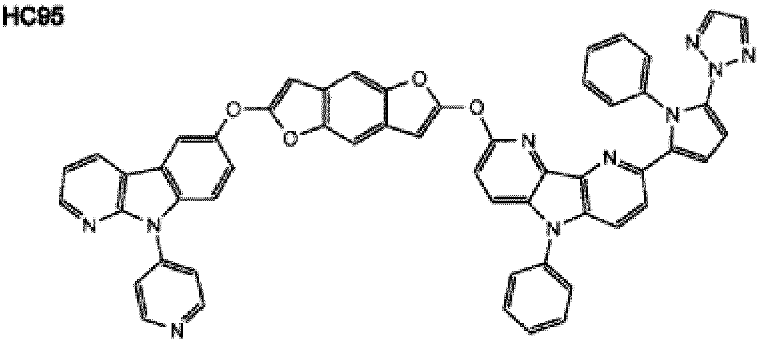

[Chem. 26]

HC96

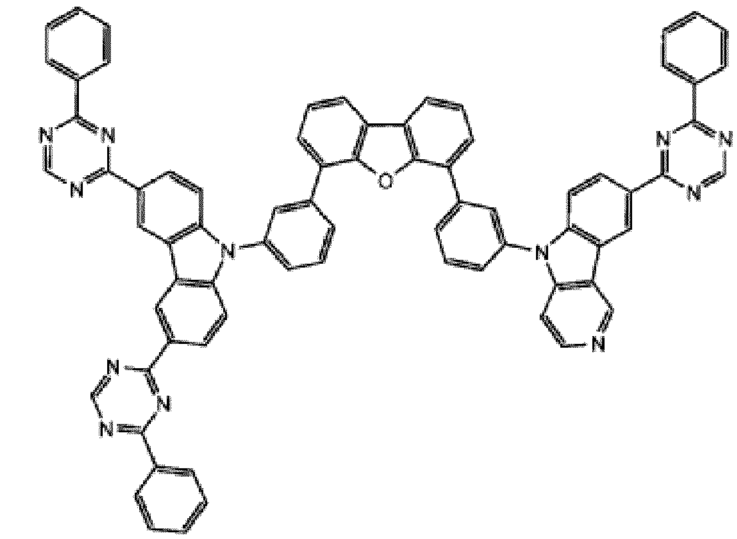

HC97

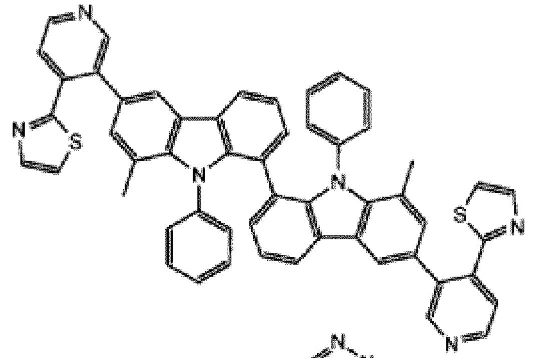

HC98

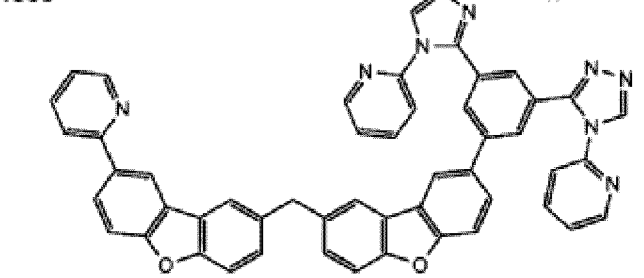

HC99

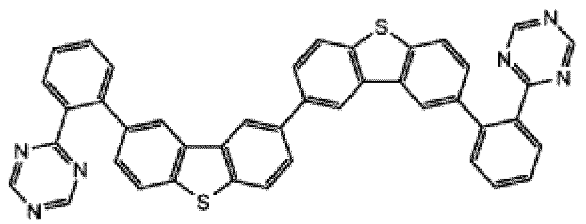

[Chem. 27]

HC100

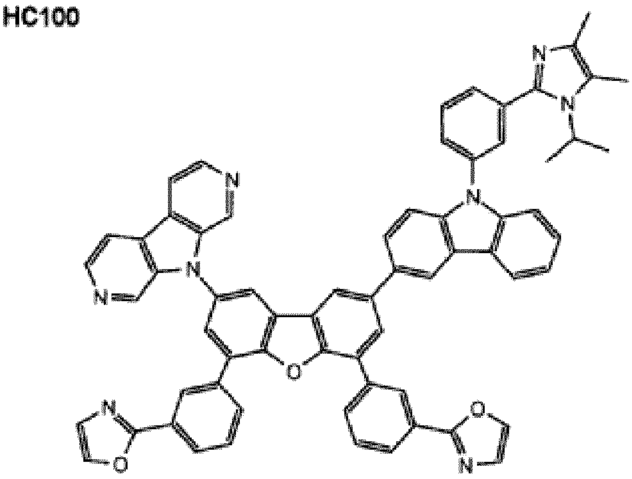

HC101

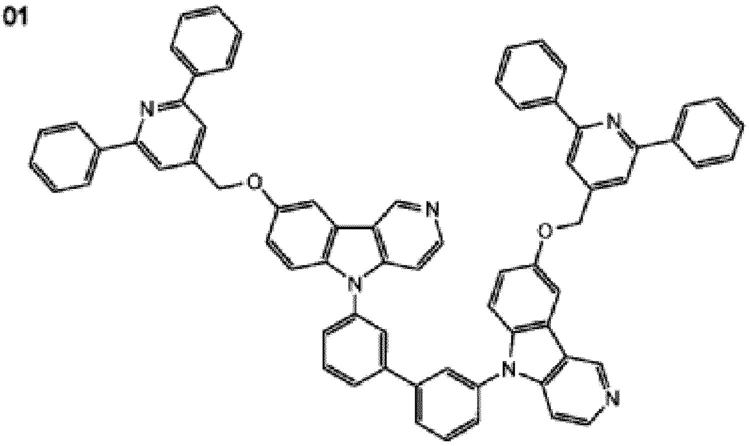

HC102

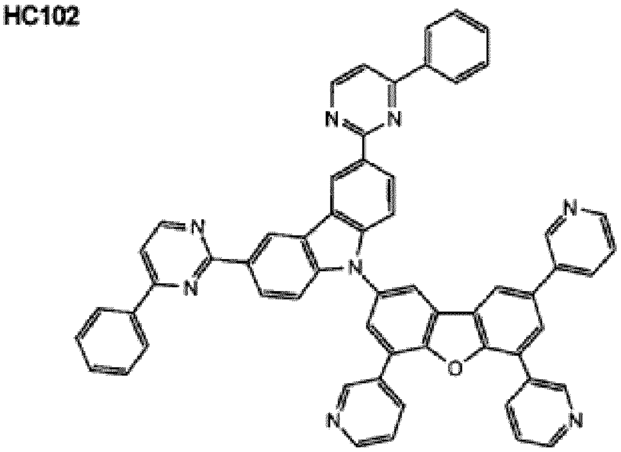

[Chem. 28]

HC103

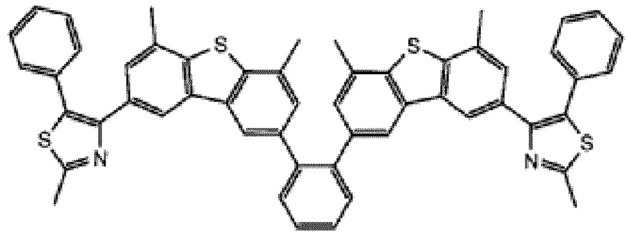

HC104

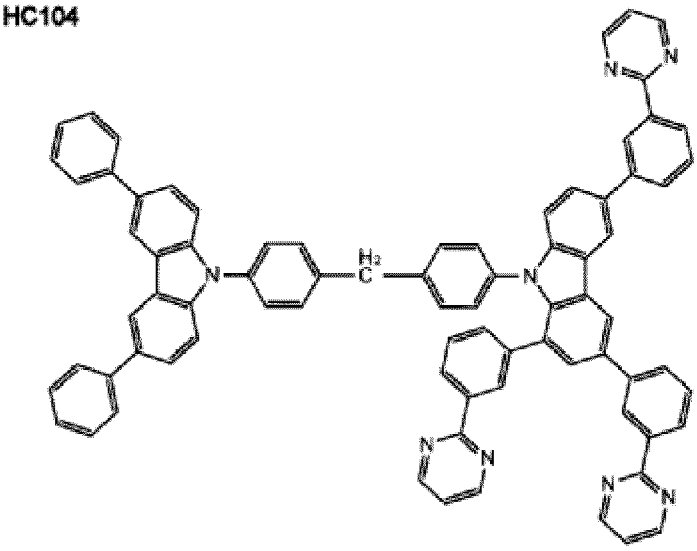

HC105

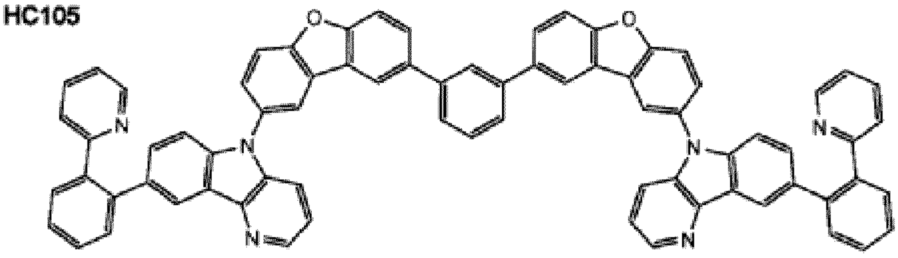

HC106

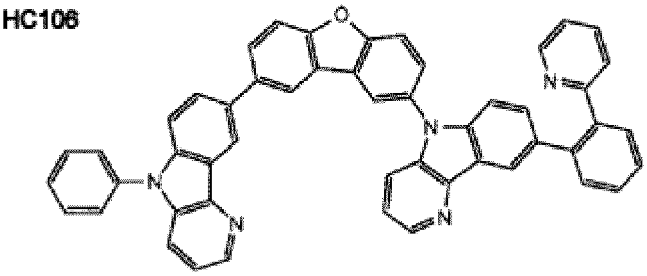

[Chem. 29]

HC107

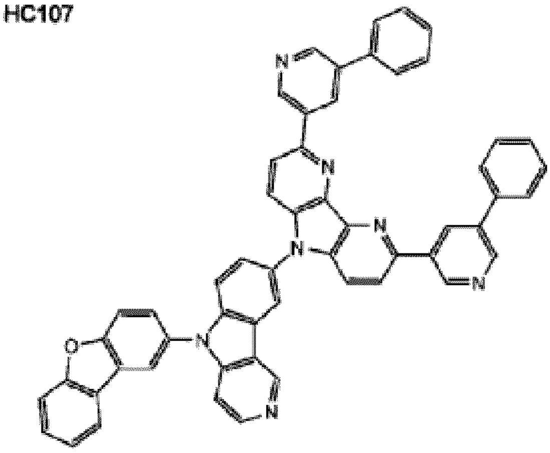

HC108

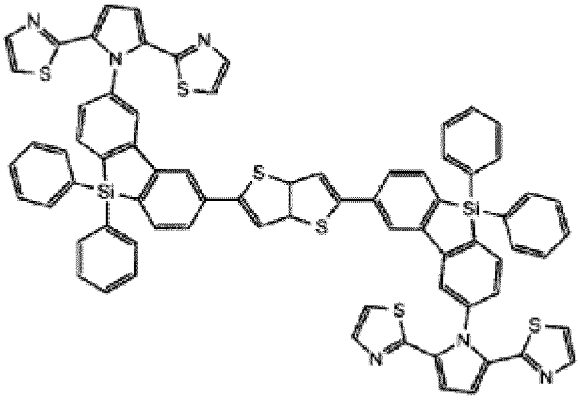

HC109

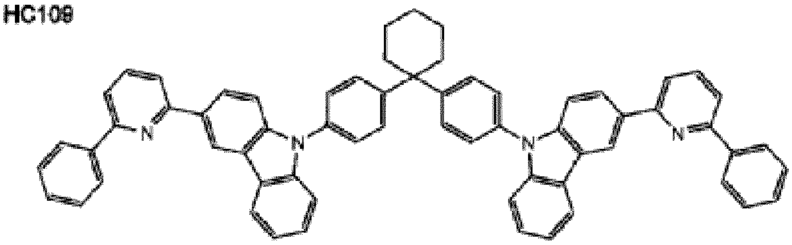

[Chem. 30]

HC110

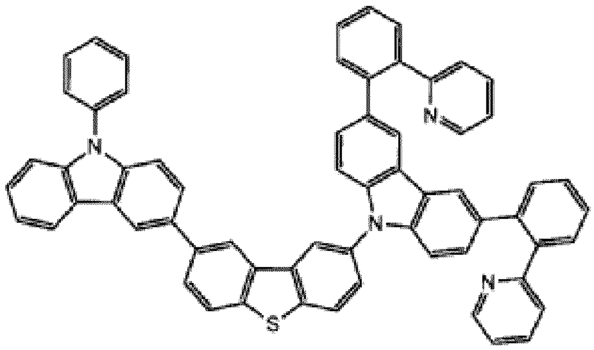

HC111

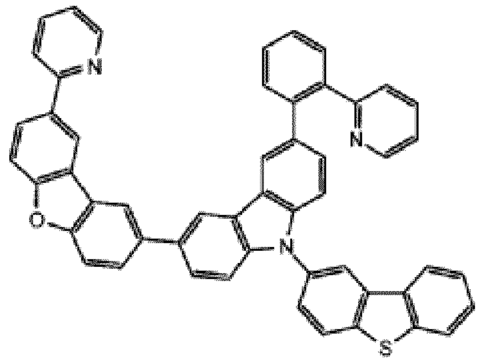

HC112

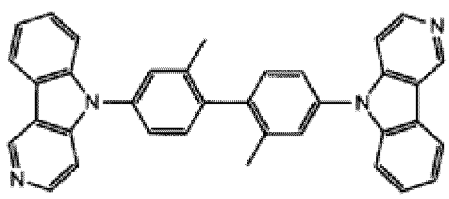

[Chem. 31]

HC113

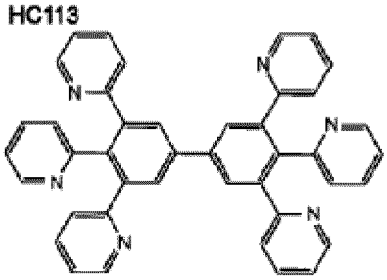

HC114

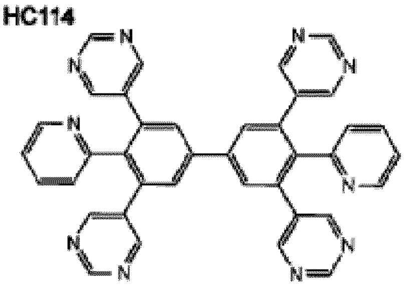

HC115

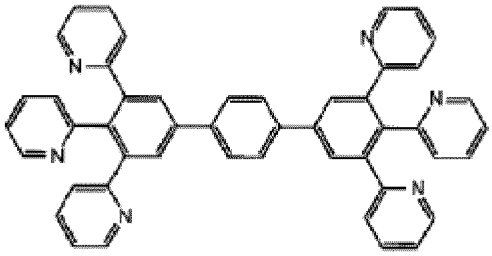

HC116

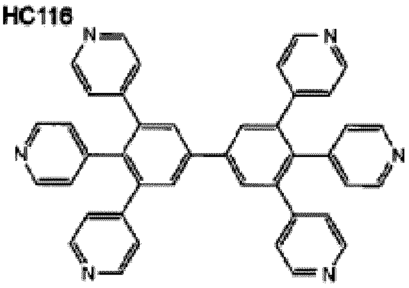

HC117

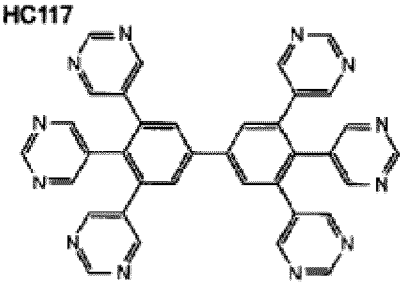

HC118

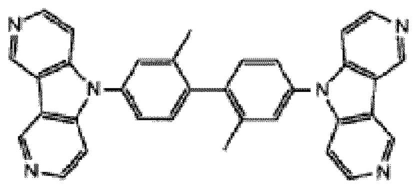

[Synthesis example of compound]

Next, as a synthesis example of a representative compound, the synthesis example of the compound represented by the structural formula HC5 is shown, but the present invention is not limited to this.

[Chem. 32]

Synthesis of Compound HC5

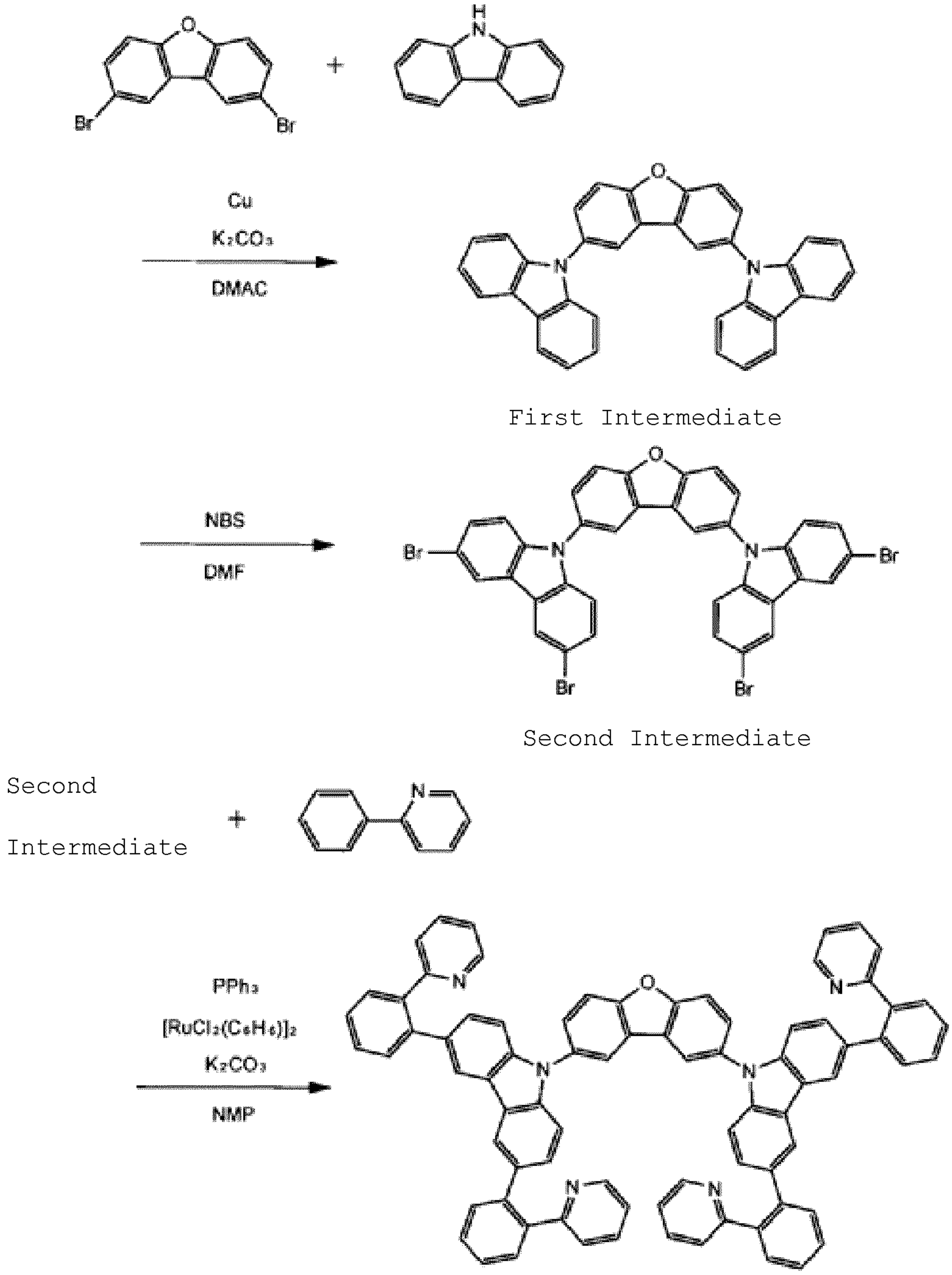


First Intermediate

Second Intermediate

Second Intermediate

Compound HC5

(1) First process: (synthesis of first intermediate)

Under nitrogen atmosphere, 2,8-dibromodibenzofuran (1.0 mole), of carbazole (2.0 moles), copper powder (3.0 moles), potassium carbonate (1.5 moles) were mixed in 300 mL of DMAc (dimethylacetamide) and then stirred for 24 hours at 130°C. After the reaction liquid thus obtained was cooled to room temperature, 1 L of toluene was added to the liquid. Then, the reaction liquid obtained by adding toluen was washed three times with distilled water. Subsequently, the solvent was distilled away from the washed layer under reduced pressure, and purification of the residue with silica gel flash chromatography (n-heptane:toluene = 4:1 to 3:1) gave a first intermediate at a yield of 85%.

(2) Second process: (synthesis of second intermediate)

At room temperature under atmospheric pressure, the first intermediate (0.5 mole) was dissolved into 100 mL of DMF (dimethylformamide), NBS (N-bromosuccinic acid imide) (2.0 moles) was added, and then stirred over one night at room temperature. The obtained precipitate was filtered and then the washing of the filtrate with methanol gave a second intermediate at a yield of 92%.

(3) Third process: (synthesis of compound having structure formula HC5)

Under nitrogen atmosphere, the second intermediate (0.25 mole), 2-phenylpyridine (1.0 mole), ruthenium complex $[(\eta_6\text{-}C_6H_6)RuCl_2]_2$ (0.05 mole), triphenylphosphine (0.2 mole), potassium carbonate (12 moles) were mixed in 3 L of NMP (N-methyl-2-pyrrolidone), and then stirred over one night at 140°C. After the reaction liquid thus obtained was cooled to room temperature, 5 L of dichloromethane was added. Then, the solution liquid obtained by adding dichloromethane was filtered. Subsequently, the solvent was distilled away from the filtrate under reduced pressure (800 Pa, 80°C), and the residue was purified with silica gel flash chromatography ($CH_2Cl_2$:$Et_3N$ = 20:1 to 10:1).

Next, after the solvent was distilled away under reduced pressure, the residue was again dissolved into dichloromethane. Subsequently, the dissolution liquid was washed with water three times. Then, after the substance obtained by the washing treatment was dried with anhydrous magnesium sulfate, distillation of the solvent was distilled away from the dried substance under reduced pressure gave the compound represented by the structural formula HC5 at a yield of 68%.

[Metal layer]

In the present embodiment, the metal layer 13 is formed of silver (Ag) or an alloy containing silver as the main component and is formed on the underlying layer 12. As a method for forming the metal layer 13, for example, a technique using a wet process such as an application method, an inkjet method, a coating method, or dip method, or a technique using a dry process such as an evaporation method (resistance heating method, EB method or the like), a sputtering method or a CVD method can be used. Among these film formation techniques, in the present embodiment, the use of an evaporation method is preferable as the method for forming the metal layer 13.

Meanwhile, in the present embodiment, since the metal layer 13 is formed on the underlying layer 12 containing a compound having a nitrogen (N) atom, sufficiently excellent conductivity can be obtained even when a high-temperature annealing treatment or the like is not performed after the film formation by an interaction effect between silver in the metal layer 13 and the compound having a nitrogen (N) atom in the underlying layer 12, to be described later. However, in the present embodiment, a high temperature annealing treatment or the like may be performed for the metal layer 13 after the film formation, as necessary.

When the metal layer 13 is formed of an alloy containing silver as the main component, examples of the alloy containing silver as the main component include silver-magnesium (AgMg), silver-copper (AgCu), silver-palladium (AgPd), silver-palladium-copper (AgPdCu), silver-indium (AgIn) and the like. Further, in the present embodiment, the content of silver in the metal layer 13 is preferably about 90% or more.

Meanwhile, in the present embodiment, the metal layer 13 may be constituted of a single layer, or may be constituted of a plurality of layers as necessary. In the latter case, the metal layer 13 may be constituted while laminating alternately a layer formed of silver and a layer formed of the silver alloy, or the metal layer 13 may be constituted while laminating a plurality of layers formed of silver alloys having different compositions and/or formation materials each other.

Furthermore, the thickness of the metal layer 13 is preferably about 20 nm or less, more preferably in the range of about 4 to 12 nm. When the thickness of the metal layer 13 is larger than 20 nm, an absorption component or reflection component at the metal layer 13 increases to thereby lower the light transmittance of the transparent conductive film 10, which is unpreferable. Moreover, when the thickness of the metal layer 13 is smaller than 4 nm, the conductivity of the metal layer 13 is insufficient, thereby being unpreferable.

Meanwhile, the material for forming the metal layer 13 is not limited to silver (Ag) or an alloy containing silver as the main component, but an arbitrary material can be used as long as the material can generate an interaction effect to be described later between the metal layer 13 and the underlying layer 12, and between the metal layer 13 and the overlying layer 14.

[Overlying layer]

The overlying layer 14 (stress-relaxing layer) is a layer provided for relaxing stress applied to the metal layer 13 in bending the transparent conductive film 10. The overlying layer 14 is formed of a compound containing a nitrogen (N) atom, and can be formed of an arbitrary material as long as the material generates an interaction effect to be described

later between silver in the metal layer 13 and a compound containing a nitrogen atom in the overlying layer 14.

That is, in the present embodiment, it is sufficient that a nitrogen atom is contained even a little in the overlying layer 14, and, as a material for forming the overlying layer 14, the use of a material in which the effective action energy ΔEef has a negative value between the overlying layer 14 and the metal layer 13 (refer to formula (1)) (ΔEef < 0) is preferable. Furthermore, in the present embodiment, more preferably the overlying layer 14 is formed of a material in which the effective action energy ΔEef is -0.01 [$\times$ $10^2$ kcal/ / (mol·$nm^2$)] or less between the overlying layer 14 and the metal layer 13. For example, the overlying layer 14 can be formed of a compound containing a heterocyclic ring including a nitrogen atom as a hetero atom, in the same way as in the underlying layer 12.

Furthermore, the upper portion of the overlying layer 14 (the portion opposite to the metal layer 13 side) may be covered, for example, with a protective layer, or may be laminated with another conductive film. In this case, in order not to damage the light transmission property of the transparent conductive film 10, the protective film and/or the conductive film is also preferably constituted of a film having light transmission property.

[Various effects]

As described above, in the transparent conductive film 10 of the present embodiment, the metal layer 13 formed of silver or an alloy containing silver as the main component is provided on the underlying layer 12 containing a compound having a nitrogen atom.

Generally, the film growth of a metal layer formed of silver or an alloy containing silver as the main component becomes a thin film growth of the nucleas growth type (VW (Volumer-Weber) type) and silver particles are easily isolated in the form of island. However, in the present embodiment, since the metal layer 13 is formed on the underlying layer 12 containing a compound having a nitrogen atom, a silver atom in the metal layer 13 interacts with a compound having a nitrogen atom contained in the underlying layer 12 in the formation process thereof, the diffusion length of a silver atom on the surface of the underlying layer 12 is reduced and the agglomeration of silver is suppressed. As the result, in the present invention, the film growth of the metal layer 13 becomes a thin film growth of the mono-layer growth type (FM (Frank-van der Merwe) type) on the underlying layer 12. Therefore, in the transparent conductive film 10 of the present embodiment, the metal layer 13 having a uniform thickness (continuous film) can be obtained even when the thickness of the metal layer 13 formed of silver or an alloy containing silver as the main component is small.

Furthermore, in particular, when forming the underlying layer 12 by using a compound in which the effective action energy ΔEef acting mutually between a compound constitutng the underlying layer 12 and silver constitutng the metal layer 13 has a value within the range shown by the formula (2), the aforementioned suppression effect of agglomeration of silver can be more reliably obtained.

As described above, according to the configuration of the transparent conductive film of the present embodiment, since the metal layer 13 that has small thickness and is uniform (continuous film) can be formed on the underlying layer 12, not only light transmission property can be secured but also sufficient electric conductivity can be obtained.

Furthermore, in the transparent conductive film of the present invention 10, the overlying layer 14 formed of the same material as that of the underlying layer 12, that is, the overlying layer 14 containing a compound having a nitrogen atom is provided on the metal layer 13. Accordingly, the interaction as described above is generated between silver in the metal layer 13 and the compound containing a nitrogen atom in the overlying layer 14 also at the interface of the metal layer 13 and the overlying layer 14, to thereby improve adhesion strength at the interface of the metal layer 13 and the overlying layer 14. As the result, stress applied to the metal layer 13 when the transparent conductive film 10 is bent can be relaxed by the overlying layer 14, and thus bending resistance is enhanced.

From the above, in the present embodiment, the transparent conductive film 10 having not only excellent conductivity and light transmission property but also excellent bending resistance can be obtained. Furthermore, in the present embodiment, since indium (In) being rare metal is not used, cost reduction is possible. Moreover, in the present embodiment, since a material that is unstable chemically such as ZnO is not used, long-period reliability of the transparent conductive film 10 can be secured.

[Use of transparent conductive film]

The transparent conductive film 10 of the present embodiment, having the aforementioned configuration can be used for various electronic devices. Examples of the electronic device include an organic electroluminescent element, an LED (light emitting Diode), a liquid crystal element, a solar cell, a touch panel, and the like. Meanwhile, in each of these electronic devices, the transparent conductive film 10 having the aforementioned configuration is applied to an electrode member that requires a light transmission property.

<2. Various Examples>

Next, the configuration and properties of various transparent conductive films actually produced (Examples 1 and 2) will be explained.

[Example 1]

In Example 1, mainly, transparent conductive films (samples 1-1 to 1-7 below) were produced while variously changing materials for forming the metal layer. Meanwhile, in produced samples of respective transparent conductive films, the size of a conductive region was set to be 5 cm × 5 cm.

(1) Sample 1-1 (one example of transparent conductive film according to the present invention)

First, in a sample 1-1, a base material formed of polyethylene terephthalate (PET) was prepared as the base material of the transparent conductive film. Subsequently, the prepared base material was fixed to a base material holder of a commercially available vacuum evaporation apparatus. Furthermore, in the sample 1-1, as each of materials for forming the underlying layer and the overlying layer, a compound represented by a structural formula No. 1 below was used, and the compound was placed in a molybdenum resistance heating boat. Then, the substrate holder and the molybdenum resistance heating boat were attached to a first vacuum chamber of the vacuum evaporation apparatus.

[Chem. 33]

No.1

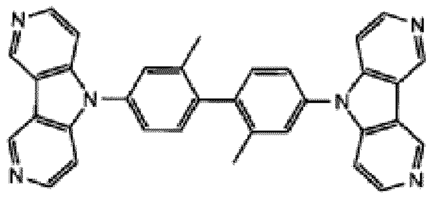

Furthermore, in the sample 1-1, silver (Ag) was prepared as a material for forming the metal layer, and the silver was placed in a tungsten resistance heating boat. Then, the tungsten resistance heating boat was attached to a second vacuum chamber of the vacuum evaporation apparatus.

Subsequently, the pressure of the first and second vacuum chambers was reduced to $4 \times 10^{-4}$ Pa in a state where the substrate holder and various resistance heating boats were mounted in the vacuum evaporation apparatus. Then, the compound was deposied on the base material at an evaporation rate of 0.1 nm/sec to 0.2 nm/sec by supplying power to the resistance heating boat in which the compound represented by the structural formula No. 1 was placed and by heating compound. Therefore, the underlying layer having a thickness of 25 nm was formed on the base material.

Subsequently, silver was deposited on the underlying layer at an evaporation rate of from 0.1 nm/sec to 0.2 nm/sec by moving the base material obtained by forming the underlying layer into the second vacuum chamber while maintaining the vacuum environment, and then by supplying power to the heating boat in which silver was placed and by heating the silver. Therefore, the metal layer having a thickness of 8 nm was formed on the underlying layer.

Subsequently, the base material obtained by forming the underlying layer and the metal layer was moved to the first vacuum chamber while maintaining the vacuum environment. Then, the compound was deposied on the metal layer at an evaporation rate of 0.1 nm/sec to 0.2 nm/sec by supplying power to the heating boat in which the compound represented by the structural formula No. 1 was placed and by heating the compound. Therefore, the overlying layer having a thickness of 25 nm was formed on the metal layer. In the example, a transparent conductive film of the sample 1-1 was produced in this way.

(2) Sample 1-2 (one example of transparent conductive film according to the present invention)

In a sample 1-2, silver-magnesium (AgMg) was used as a material for forming the metal layer. Meanwhile, in the sample 1-2, the ratio between a magnesium content and a silver content was set to be Mg: Ag = 1:9 (10%: 90%). Furthermore, in the sample 1-2, the thickness of the metal layer was set to be 8 nm. Moreovr, in the example, the transparent conductive film of the sample 1-2 was produced in the same way as in the transparent conductive film of the sample 1-1 except for the configuration of the metal layer.

(3) Sample 1-3 (one example of transparent conductive film according to the present invention)

In a sample 1-3, silver-magnesium (AgMg) was used as a material for forming the metal layer. Meanwhile, in the sample 1-3, the ratio between a magnesium content and a silver content was set to be Mg: Ag = 3:7 (30%:70%). In addition, in the sample 1-3, the thickness of the metal layer was set to be 8 nm. Furthermore, in the example, the transparent conductive film of the sample 1-3 was produced in the same way as in the transparent conductive film of the sample 1-1 except for the configuration of the metal layer.

(4) Transparent conductive films in Comparative Example 1 (samples 1-4 to 1-7)

In the example, transparent conductive films in Comparative Example 1 (samples 1-4 to 1-7) as described below were produced in order to make a comparison of properties among samples 1-1 to 1-3 being transparent conductive films according to the present invention and samples 1-4 to 1-7.

(4-1) Sample 1-4

In a sample 1-4, no underlying layer was formed and the metal layer was formed from ITO. Furthermore, in the sample 1-4, the thickness of the metal layer was set to be 150 nm. The transparent conductive film of the sample 1-4 was produced in the same way as in the transparent conductive film of the sample 1-1 except for these configurations.

(4-2) Sample 1-5

In a sample 1-5, no underlying layer was formed and the metal layer was formed as Ag film having a thickness of 15 nm (Ag thick film). The transparent conductive film of the sample 1-5 was produced in the same way as in the transparent conductive film of the sample 1-1 except for these configurations.

(4-3) Sample 1-6

In a sample 1-6, no underlying layer was formed and the metal layer was formed as Ag film having a thickness of 8 nm. The transparent conductive film of the sample 1-6 was produced in the same way as in the transparent conductive film of the sample 1-1 except for these configurations.

(4-4) Sample 1-7

In a sample 1-7, no overlying layer was formed and the metal layer was formed as Ag film having a thickness of 8 nm. The transparent conductive film of the sample 1-7 was produced in the same way as in the transparent conductive film of the sample 1-1 except for these configurations.

[Evaluation of samples in Example 1]

In Example 1, a light transmission property, conductivity and bending resistance were evaluated for transparent conductive films of respective samples (samples 1-1 to 1-7).

(1) Evaluation of light transmission property

In the evaluation of the light transmission property, the light transmittance at a wavelength of 550 nm was measured for respective samples. Meanwhile, the light transmittance was measured using a spectrophotometer (U-3300, manufactured by Hitachi, Ltd.). Then, the light transmission property of respective samples was evaluated on the basis of the measured light transmittance.

The light transmission property was evaluated in accordance with the standard described below.

A: the light transmittance was 90% or more.
B: the light transmittance was 80% or more and less than 90%.
C: the light transmittance was 70% or more and less than 80%.
D: the light transmittance was 50% or more and less than 70%.
E: the light transmittance was less than 50%.

(2) Evaluation of conductivity

In the evaluation of conductivity, the sheet resistance value of each of samples was measured. The sheet resistance value was measured by a 4-terminal 4-probe method constant current application systemusing a resistivity meter (MCP-T610, manufactured by Mitsubishi Chemical Corporation). In addition, on the basis of the measured sheet resistance value, the conductivity of respective samples was evaluated.
The conductivity was evaluated in accordance with the standard described below.

A: the sheet resistance value was less than 10 Ω/sq.
B: the sheet resistance value was 10 Ω/sq. or more and less than 50 Ω/sq.
C: the sheet resistance value was 50 Ω/sq. or more and less than 100 Ω/sq.
D: the sheet resistance value was 100 Ω/sq. or more and less than 300 Ω/sq.
E: the sheet resistance value was 300 Ω/sq. or more.

(3) Evaluation of bending resistance

In the evaluation of bending resistance, each of samples (transparent conductive film) was wound around the surface of a metal rod having a diameter of 9 mm with the surface on the overlying layer side of respective samples facing the outside (side opposite to the metal rod side), and the state was held for 15 seconds. Then, sheet resistance values before and after the winding operation were measured using a resistivity meter (MCP-T610, manufactured by Mitsubishi Chemical Corporation), and a resistance change rate of respective samples was obtained on the basis of a formula below.

Resistance change rate [%] = {(sheet resistance value after winding operation)/(sheet resistance value before winding operation)} × 100

Then, on the basis of the calculated resistance change rate of the sheet resistance value, the bending resistance of respective samples was evaluated. Meanwhile, the bending resistance was evaluated in accordance with the standard described below.
A: the resistance change rate was less than 10%, which was at a level without practical problem.
B: the resistance change rate was 10% or more and less than 30%, which was at a level without practical problem.
C: the resistance change rate was 30% or more and less than 50%, which was at a level without practical problem.
D: the resistance change rate was 50% or more and less than 100%, which was at a level with practical problem.
E: the resistance change rate was 100% or more, which was at a level with practical problem.

(4) Evaluation results

Results of various evaluation tests carried out for transparent conductive films of the respective produced samples (samples 1-1 to 1-7) are shown in Table 1 below. Meanwhile, in Table 1 below, film configurations of respective samples are also described.

[Table 1]

| Sample No. | | 1-1 (Present invention) | 1-2 (Present invention) | 1-3 (Present invention) | 1-4 (Comparative Example) | 1-5 (Comparative Example) | 1-6 (Comparative Example) | 1-7 (Comparative Example) |
|---|---|---|---|---|---|---|---|---|
| Film configuration | Overlying | No.1 | No.1 | No.1 | No.1 | No.1 | No.1 | - |
| | Metal | Ag | MgAg (1:9) | MgAg (3:7) | ITO | Ag thick film | Ag | Ag |
| | Underlying | No.1 | No.1 | No.1 | - | - | - | No.1 |
| | Base material | Alkali-free glass | Alkali-free glass | Alkali-free glass | Alkali-free glass | Alkali-free glass | Alkali-free glass | Alkali-free glass |
| Transmission property | | A | A | A | A | E | C | C |
| Conductivity | | A | B | C | B | A | E | A |
| Bending resistance | | A | A | A | E | B | C | E |

As is clear from Table 1, for samples 1-1 to 1-3 which are transparent conductive films according to the present invention, all of the light transmission property, conductivity and bending property were rated as "C" or higher. In contrast, for samples 1-4 to 1-7 in Comparative Example 1, any of the light transmission property, conductivity and bending property was rated as "E".

From the evaluation results, it was known that a transparent conductive film excellent in all of the light transmission property, conductivity and bending property was able to be obtained by adopton of a structure of sandwiching the metal layer formed of silver or an alloy containing silver as the main component, between the underlying layer and the overlying layer formed of a compound containing a nitrogen atom as the film configuration thereof, as in the case for the transparent conductive film of the present invention.

Moreover, it was found from a comparison among samples 1-1 to 1-3 that, in the transparent conductive film of the present invention, properties of the light transmission property and conductivity were further enhanced by setting the ratio of silver contained in the metal layer to be 90% or more.

[Example 2]

In Example 2, transparent conductive films (samples 2-1 to 2-5 below) were produced while variously changing the material for forming the overlying layer.

(1) Sample 2-1 (one example of the transparent conductive film according to the present invention)

In sample 2-1, a compound represented by a structural formula No. 2 below was used as a material for forming the overlying layer, and the thickness of the overlying layer was set to be 25 nm. Furthermore, in the example, the transparent conductive film of sample 2-1 was produced in the same way as in the transparent conductive film of sample 1-1 except for the configuration of the overlying layer.

[Chem. 34]

No.2

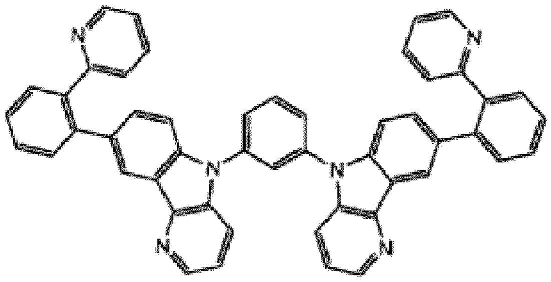

(2) Sample 2-2 (one example of transparent conductive film according to the present invention)

In sample 2-2, a compound represented by a structural formula No. 3 below was used as a material for forming the overlying layer, and the thickness of the overlying layer was set to be 25 nm. Moreover, in the example, the transparent conductive film of sample 2-2 was produced in the same way as in the transparent conductive film of sample 1-1 except for the configuration of the overlying layer.

[Chem. 35]

No.3

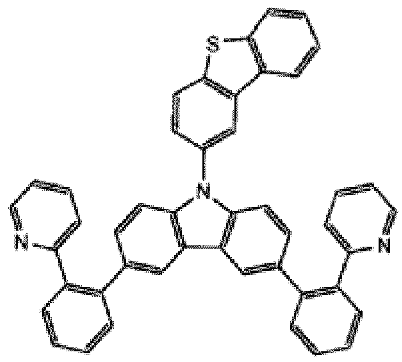

(3) Sample 2-3 (one example of transparent conductive film according to the present invention)

In sample 2-3, a compound represented by a structural formula No. 4 below was used as a material for forming the overlying layer, and the thickness of the overlying layer was set to be 25 nm. Furthermore, in the example, the transparent conductive film of sample 2-3 was produced in the same way as in the transparent conductive film of sample 1-1 except for the configuration of the overlying layer.

[Chem. 36]

No.4

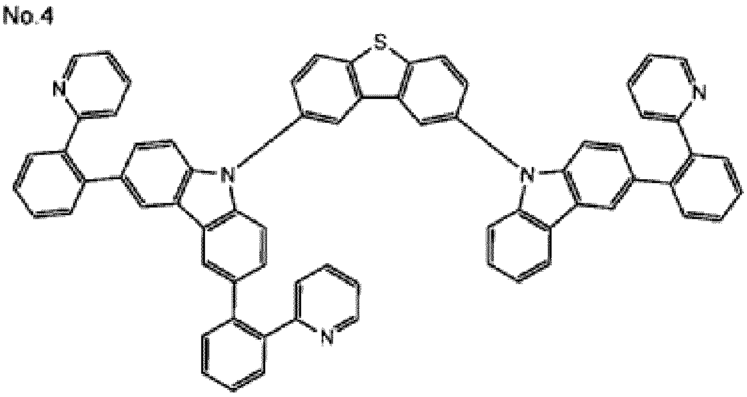

(4) Sample 2-4 (one example of transparent conductive film according to the present invention)

In sample 2-4, a compound represented by a structural formula No. 5 below was used as a material for forming the overlying layer, and the thickness of the overlying layer was set to be 25 nm. Moreover, in the example, the transparent conductive film of sample 2-4 was produced in the same way as in the transparent conductive film of sample 1-1 except for the configuration of the overlying layer.

[Chem. 37]

No.5

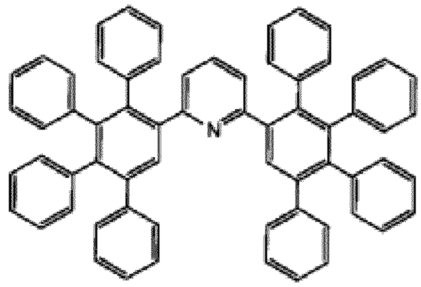

(5) Transparent conductive film in Comparative Example 2 (sample 2-5)

In the example, a transparent conductive film in Comparative Example 2 (sample 2-5) as described below was produced in order to make a comparison of properties among samples 2-1 to 2-4 being transparent conductive films according to the present invention and sample 2-5.

In sample 2-5, anthracene not containing a nitrogen atom was used as a material for forming the overlying layer, and the thickness of the overlying layer was set to be 25 nm. Furthermore, in the example, the transparent conductive film of sample 2-5 was produced in the same way as in the transparent conductive film of sample 1-1 except for the configuration of the overlying layer.

[Evaluation and evaluation results of samples in Example 2]

In Example 2, for the produced transparent conductive films of respective samples (samples 2-1 to 2-5), the light transmission property, conductivity and bending resistance were evaluated in the same way as in Example 1. Meanwhile, the evaluation standard for respective properties was the same as the aforementioned evaluation standard in Example 1.

Results of various evaluation tests carried out for the aforementioned respective samples produced (samples 2-1 to 2-5) are shown in Table 2 below. Meanwhile, in Table 2 below, evaluation results of sample 1-1 in which both of the overlying layer and the underlying layer are formed of the compound represented by the structural formula No. 1 are shown together. Furthermore, in Table 2 below, the materials for forming the overlying layer and the values of the effective action energy ΔEef acting between the overlying layer and the metal layer, in respective samples are described together.

[Table 2]

| Sample No. | 1-1 (Present invention) | 2-1 (Present invention) | (Present invention) | (Present invention) | 2-4 (Present invention) | (Comparative Example) |
|---|---|---|---|---|---|---|
| Overlying layer | No.1 | No.2 | No.3 | No.4 | No.5 | Anthracene |
| Transmission property | A | A | A | A | A | A |
| Conductivity | A | A | A | A | A | A |
| ΔEef [x $10^2$kcal/ (mol·$nm^2$)] | -0.332 | -0.230 | -0.162 | -0.137 | -0.057 | 0.000 |
| Bending resistance | A | A | B | C | C | D |

As is clear from Table 2, in the evaluation of the light transmission property and conductivity, all the samples were rated as "A". However, in the evaluation of the bending property, it was found that a better property was obtained for samples 2-1 to 2-4 being transparent conductive films according to the present invention as compared with the evaluation result of the sample 2-5 in Comparative Example 2.

From the aforementioned evaluation result, it was found that the bending property was improved by forming the overlying layer with a compound containing a nitrogen atom even a little, that is, a compound with negative effective

action energy ΔEef, as in the case of the transparent conductive film of the present invention.

Reference Signs List

10: transparent conductive film, 11: base material, 12: underlying layer, 13: metal layer, 14: overlying layer

## Claims

1. A transparent conductive film comprising:

   a base material;
   a first compound layer containing nitrogen, which is provided on the base material;
   a metal layer having light transmission property, which is provided on the first compound layer; and
   a second compound layer containing nitrogen, which is provided on the metal layer.

2. The transparent conductive film according to claim 1, wherein silver is contained in the metal layer at a ratio of 90% or more.

3. The transparent conductive film according to claim 1 or 2, wherein an effective action energy ΔEef acting between the metal layer and nitrogen in the second compound layer has a negative value.

FIG. 1

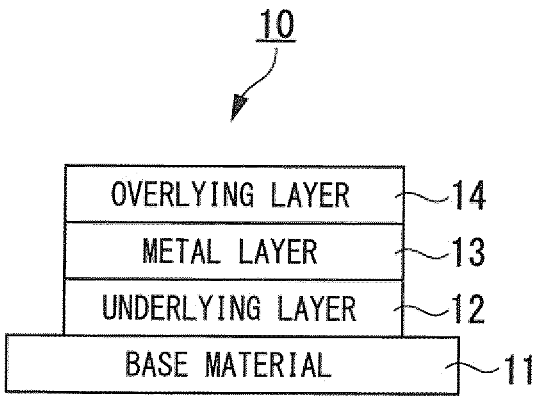
10
OVERLYING LAYER
14
METAL LAYER
13
UNDERLYING LAYER
12
BASE MATERIAL
11

## INTERNATIONAL SEARCH REPORT

International application No.
PCT/JP2013/061167

A. CLASSIFICATION OF SUBJECT MATTER
*H01B5/14*(2006.01)i, *B32B15/01*(2006.01)i, *H01L51/50*(2006.01)i, *H05B33/26*(2006.01)i, *H05B33/28*(2006.01)i

According to International Patent Classification (IPC) or to both national classification and IPC

B. FIELDS SEARCHED

Minimum documentation searched (classification system followed by classification symbols)
H01B5/14, B32B15/01, H01L51/50, H05B33/26, H05B33/28

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2011-77028 A (Hitachi Displays, Ltd.), 14 April 2011 (14.04.2011), paragraphs [0005], [0007], [0024], [0033] to [0037], [0043], [0061], [0080] to [0086] & US 2011/0057920 A1 | 1,2<br>1,2<br>3 |
| Y<br>A | JP 2010-251675 A (Konica Minolta Holdings, Inc.), 04 November 2010 (04.11.2010), paragraphs [0021] to [0047], [0138], [0140], [0196] & US 2012/0261654 A1 & US 2012/0326601 A1 & US 2009/0284138 A1 & EP 2123733 A2 & EP 2460866 A2 & EP 2479234 A1 | 1,2<br>3 |

☒ Further documents are listed in the continuation of Box C.   ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 03 July, 2013 (03.07.13) | 16 July, 2013 (16.07.13) |
| Name and mailing address of the ISA/<br>Japanese Patent Office<br><br>Facsimile No. | Authorized officer<br><br><br>Telephone No. |

Form PCT/ISA/210 (second sheet) (July 2009)

**INTERNATIONAL SEARCH REPORT**

International application No.
PCT/JP2013/061167

C (Continuation). DOCUMENTS CONSIDERED TO BE RELEVANT

| Category* | Citation of document, with indication, where appropriate, of the relevant passages | Relevant to claim No. |
|---|---|---|
| E,A | WO 2013/073356 A1 (Konica Minolta, Inc.), 23 May 2013 (23.05.2013), entire text; all drawings (Family: none) | 1-3 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002015623 A
- JP 2006164961 A
- JP 2009151963 A
- JP 2004068143 A